# EUROPEAN PATENT APPLICATION

(11) **EP 4 513 543 A1**
(43) Date of publication of application: **26.02.2025**
(21) Application number: 24168133.7
(22) Date of filing: 02.04.2024
(51) Int. Cl.: H01L 21/8234, H01L 27/088, H01L 29/06, H01L 29/775, H01L 29/08, H01L 29/10, H01L 29/66, H01L 29/417, B82Y 10/00

(54) **SEMICONDUCTOR DEVICE**

(30) Priority: 23.08.2023 KR 20230110241
(71) Applicant: Samsung Electronics Co., Ltd., Suwon-si, Gyeonggi-do 16677 (KR)
(72) Inventor: PARK, Wooseok, 16677 Suwon-si (KR); SONG, Wookhwan, 16677 Suwon-si (KR); HWANG, Donghoon, 16677 Suwon-si (KR); KANG, Myungil, 16677 Suwon-si (KR); RYU, Taehyun, 16677 Suwon-si (KR); LEE, Namhyun, 16677 Suwon-si (KR)
(74) Representative: Marks & Clerk LLP

(57) **Abstract**

A semiconductor device may include a first active pattern, a second active pattern spaced apart at a first distance from the first active pattern, a third active pattern spaced apart at a second distance from the second active pattern, a first device isolation layer between the first and second active patterns, a second device isolation layer between the second and third active patterns, a first channel structure overlapping the first active pattern, a second channel structure overlapping the second active pattern, a third channel structure overlapping the third active pattern, and a separation dielectric layer between the first and second channel structures. The separation dielectric layer may overlap the first device isolation layer. A level of a top surface of the first device isolation layer may be higher than a level of a top surface of the second device isolation layer.

## Description

### BACKGROUND

Inventive concepts relate to a semiconductor device, and more particularly, to a semiconductor device including a separation dielectric layer.

A semiconductor device may include an integrated circuit having metal oxide semiconductor field effect transistors (MOSFETs). As size and design rule of the semiconductor device are gradually decreased, sizes of the MOSFETs also increasingly may be scaled down. The scale down of MOSFETs may deteriorate operating characteristics of the semiconductor device. Accordingly, research has been variously developed to manufacture the semiconductor device having excellent performances while overcoming limitations due to integration of the semiconductor device.

### SUMMARY

Some embodiments of inventive concepts provide a semiconductor device with increased reliability and improved electrical properties.

According to some embodiments of inventive concepts, a semiconductor device may include: a first active pattern; a second active pattern spaced apart at a first distance from the first active pattern; a third active pattern spaced apart at a second distance from the second active pattern; a first device isolation layer between the first active pattern and the second active pattern; a second device isolation layer between the second active pattern and the third active pattern; a first channel structure overlapping the first active pattern; a second channel structure overlapping the second active pattern; a third channel structure overlapping the third active pattern; and a separation dielectric layer between the first channel structure and the second channel structure. The second active pattern may be between the first active pattern and the third active pattern. The first distance may be less than the second distance. The separation dielectric layer may overlap the first device isolation layer. A level of a top surface of the first device isolation layer may be higher than a level of a top surface of the second device isolation layer.

The semiconductor device may comprise a semiconductor substrate. The first, second, and third active patterns may each be an upper portion of the semiconductor substrate.

The separation dielectric layer may vertically overlap the first device isolation layer. In other words, if a substrate of the semiconductor device extends in a first direction and a second direction, the separation dielectric layer may overlap the first device isolation layer in a third direction that is perpendicular to the first direction and the second direction.

In some embodiments, the separation dielectric layer and the first device isolation layer include different dielectric materials from each other. In other words, the separation dielectric layer may comprise a first dielectric material (e.g. silicon nitride), whilst the first device isolation later may comprise a second dielectric material (e.g. silicon oxide), which is different from the second dielectric material. According to some embodiments of inventive concepts, a semiconductor device may include: a first active pattern and a second active pattern adjacent to each other; a device isolation layer between the first active pattern and the second active pattern; a first channel structure overlapping the first active pattern; a second channel structure overlapping the second active pattern; a first gate electrode overlapping the first channel structure; a second gate electrode overlapping the second channel structure; and a separation dielectric layer between the first channel structure and the second channel structure and between the first gate electrode and the second gate electrode. A level of a bottom surface of the separation dielectric layer may be lower than a level of a top surface of the device isolation layer.

According to some embodiments of inventive concepts, a semiconductor device may include: a first active pattern and a second active pattern that are adjacent to each other; a device isolation layer between the first active pattern and the second active pattern; a first channel structure overlapping the first active pattern; a second channel structure overlapping the second active pattern; a first gate electrode overlapping the first channel structure; a second gate electrode overlapping the second channel structure; a first upper source/drain pattern connected to the first channel structure; a second upper source/drain pattern connected to the second channel structure; a first lower dielectric pattern between the first channel structure and the first active pattern; a second lower dielectric pattern between the second channel structure and the second active pattern; and a separation dielectric layer between the first channel structure and the second channel structures, between the first gate electrode and the second gate electrode, between the first upper source/drain pattern and the second upper source/drain pattern, and between the first lower dielectric pattern and the second lower dielectric pattern. The separation dielectric layer may overlap the device isolation layer. The separation dielectric layer and the device isolation layer may include different dielectric materials from each other.

At least some of the above and other features of the invention are set out in the claims.

### BRIEF DESCRIPTION OF DRAWINGS

FIG. 1A illustrates a plan view showing a semiconductor device according to some embodiments.
FIG. 1B illustrates a cross-sectional view taken along line A-A' of FIG. 1A.
FIG. 1C illustrates a cross-sectional view taken along line B-B' of FIG. 1A.
FIG. 1D illustrates a cross-sectional view taken along line C-C' of FIG. 1A.
FIG. 1E illustrates a cross-sectional view taken along line D-D' of FIG. 1A.
FIG. 1F illustrates a cross-sectional view taken along line E-E' of FIG. 1A.
FIG. 1G illustrates an enlarged view showing section F1 of FIG. 1B.
FIGS. 2A to 15C illustrate cross-sectional views showing a method of fabricating a semiconductor device according to some embodiments.
FIGS. 16A, 16B, and 16C illustrate cross-sectional views showing a semiconductor device according to some embodiments.
FIG. 16D illustrates an enlarged view showing section F2 of FIG. 16A.
FIGS. 17 to 25B illustrate cross-sectional views showing a method of fabricating a semiconductor device according to some embodiments.
FIGS. 26A and 26B illustrate cross-sectional views showing a semiconductor device according to some embodiments.

### DETAILED DESCRIPTION

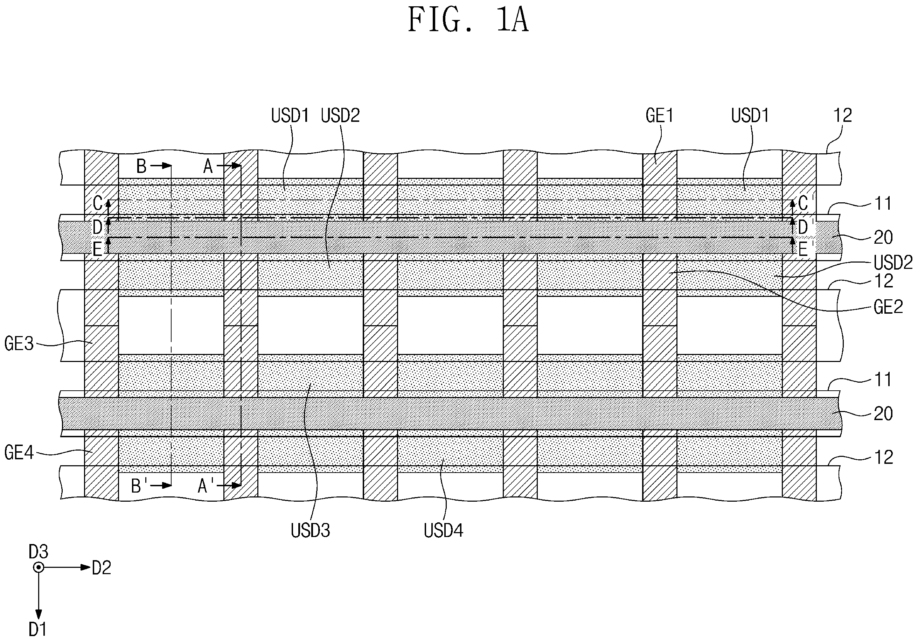

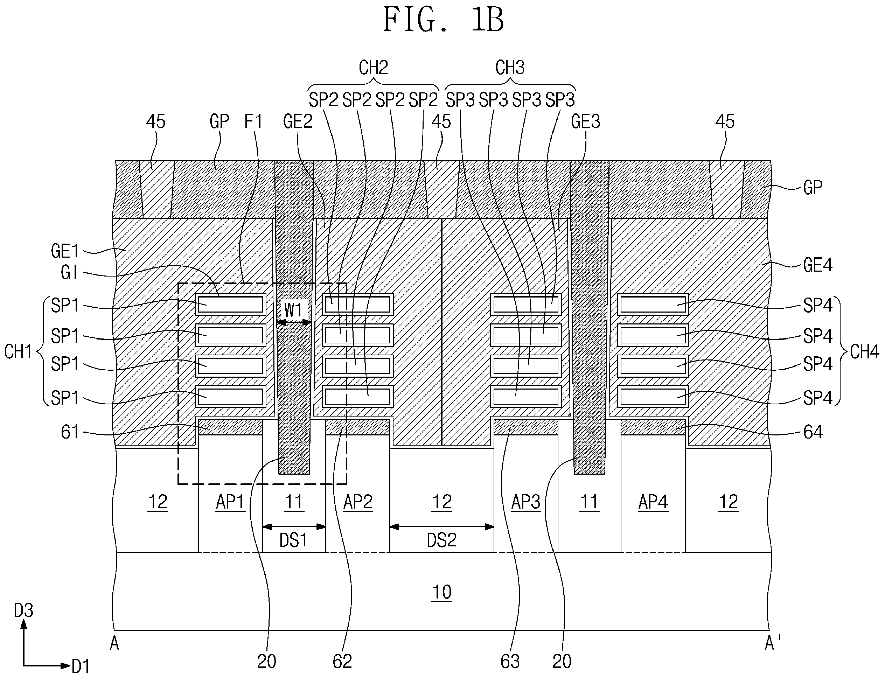

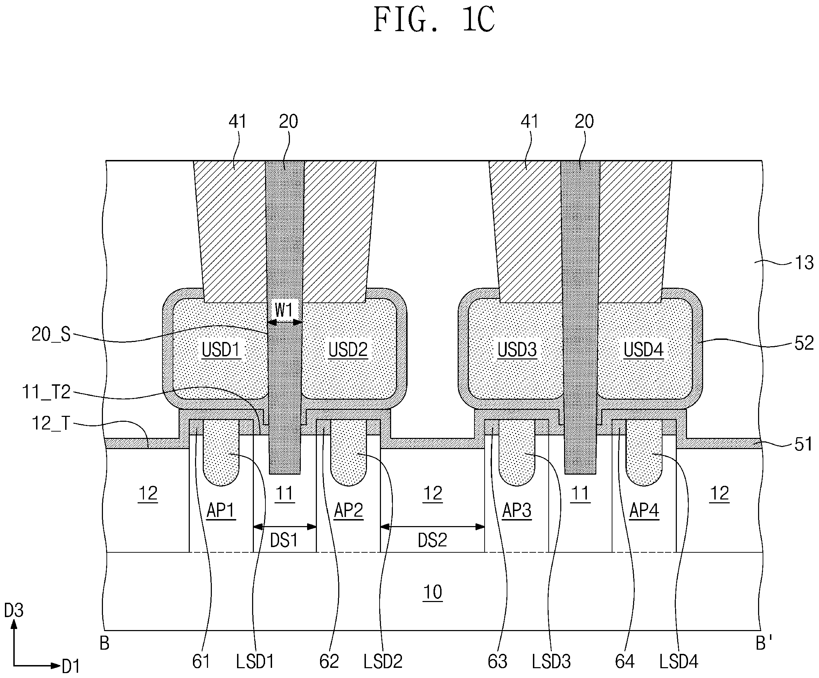

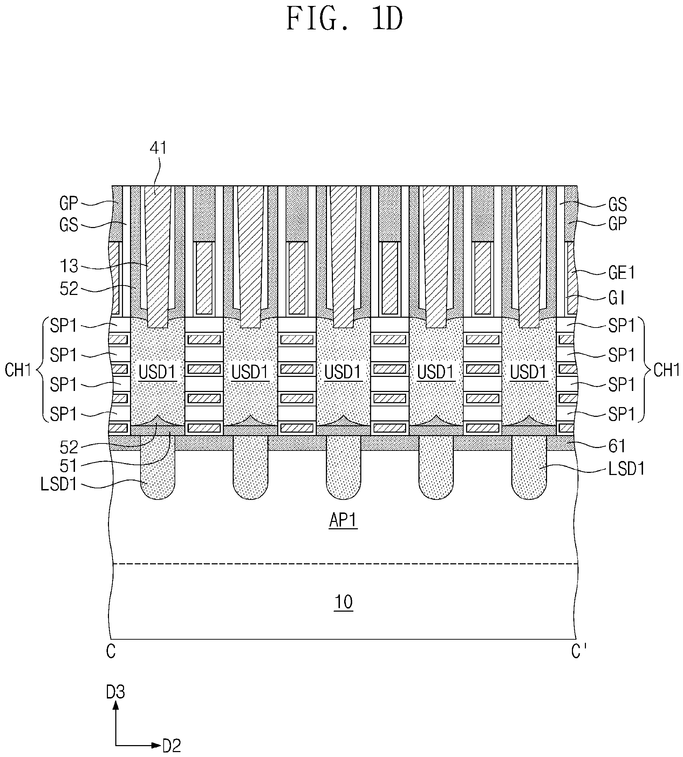

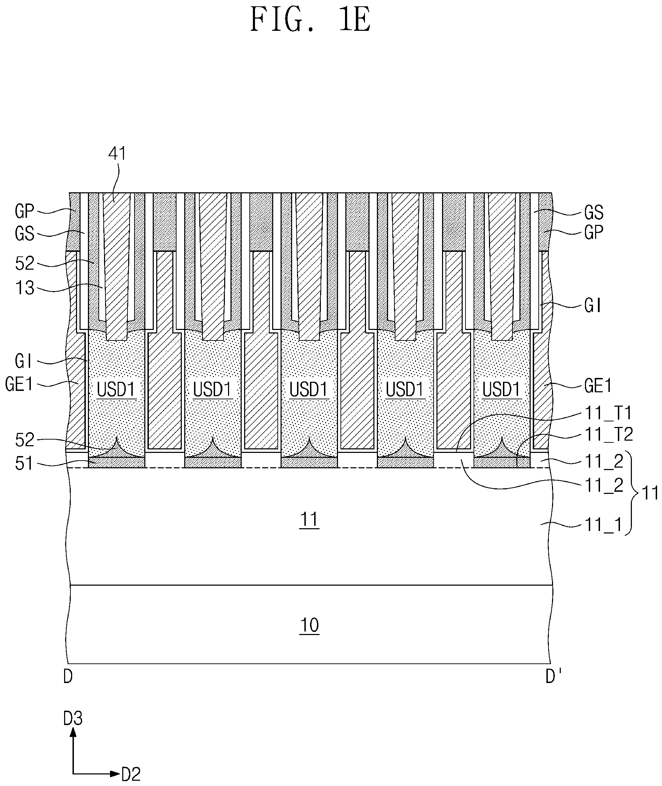

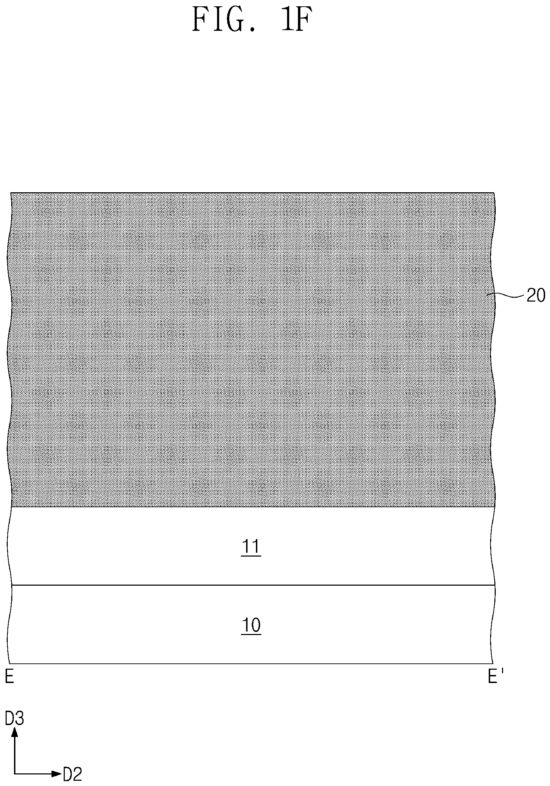

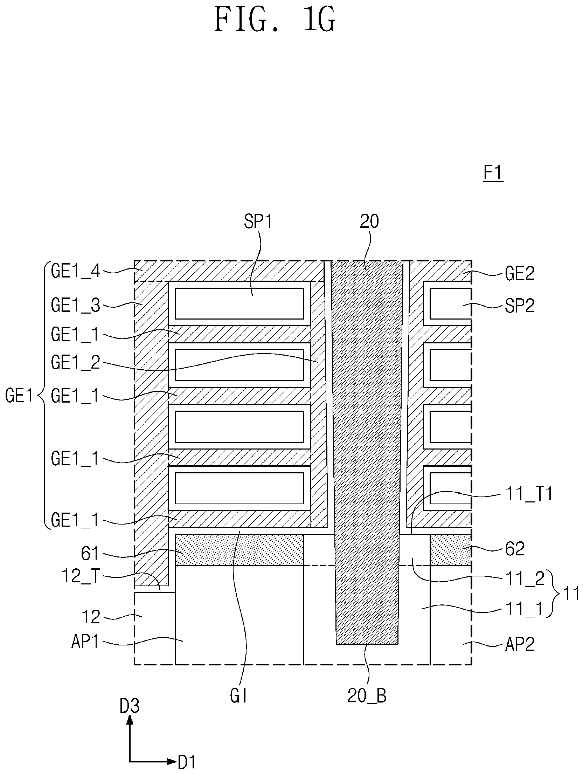

FIG. 1A illustrates a plan view showing a semiconductor device according to some embodiments. FIG. 1B illustrates a cross-sectional view taken along line A-A' of FIG. 1A. FIG. 1C illustrates a cross-sectional view taken along line B-B' of FIG. 1A. FIG. 1D illustrates a cross-sectional view taken along line C-C' of FIG. 1A. FIG. 1E illustrates a cross-sectional view taken along line D-D' of FIG. 1A. FIG. 1F illustrates a cross-sectional view taken along line E-E' of FIG. 1A. FIG. 1G illustrates an enlarged view showing section F1 of FIG. 1B.

Referring to FIGS. 1A, 1B, 1C, 1D, 1E, 1F, and 1G, a semiconductor device may include a substrate 10. The substrate 10 may be provided thereon with logic transistors included in a logic circuit. The substrate 10 may be a semiconductor substrate, a dielectric substrate, a silicon-on-insulator (SOI) substrate, or a germanium-on-insulator (GOI) substrate. The semiconductor substrate may include, for example, silicon (Si), germanium (Ge), silicon-germanium (SiGe), gallium-phosphorus (GaP), or gallium-arsenic (GaAs).

The substrate 10 may have a plate shape elongated along a plane defined in a first direction D1 and a second direction D2. The first direction D1 and the second direction D2 may intersect each other. For example, the first direction D1 and the second direction D2 may be horizontal directions that are orthogonal to each other.

The substrate 10 may include active patterns AP1, AP2, AP3, and AP4. Each of the active patterns AP1, AP2, AP3, and AP4 may extend in the second direction D2. Each of the active patterns AP1, AP2, AP3, and AP4 may be an upper portion of the substrate 10, and the upper portion may protrude in a third direction D3. The third direction D3 may intersect the first direction D1 and the second direction D2. For example, the third direction D3 may be a vertical direction perpendicular to the first direction D1 and the second direction D2.

The active patterns AP1, AP2, AP3, and AP4 may include a first active pattern AP1, a second active pattern AP2, a third active pattern AP3, and a fourth active pattern AP4. The first, second, third, and fourth active patterns AP1, AP2, AP3, and AP4 may be sequentially arranged along the first direction D1. The first, second, third, and fourth active patterns AP1, AP2, AP3, and AP4 may be spaced apart from each other the first direction D1. The first active pattern AP1 and the second active pattern AP2 may be adjacent to each other in the first direction D1. The third active pattern AP3 and the fourth active pattern AP4 may be adjacent to each other in the first direction D1. The second active pattern AP2 may be disposed between the first and third active patterns AP1 and AP3. A first distance DS1 in the first direction D1 between the first active pattern AP1 and the second active pattern AP2 may be less than a second distance DS2 in the first direction D1 between the second active pattern AP2 and the third active pattern AP3.

The substrate 10 may be provided thereon with first device isolation layers 11 and second device isolation layers 12. The first device isolation layers 11 and the second device isolation layers 12 may be alternately arranged along the first direction D1. One of the first device isolation layers 11 may be provided between the first and second active patterns AP1 and AP2. Another of the first device isolation layers 11 may be provided between the third and fourth active patterns AP3 and AP4. One of the second device isolation layers 12 may be provided between the second and third active patterns AP2 and AP3.

A width in the first direction D1 of the first device isolation layer 11 provided between the first and second active patterns AP1 and AP2 may be less than a width in the first direction D1 of the second device isolation layer 12 provided between the second and third active patterns AP2 and AP3. The first distance DS1 may be the same as the width in the first direction D1 of the first device isolation layer 11 provided between the first and second active patterns AP1 and AP2. The second distance DS2 may be the same as the width in the first direction D1 of the second device isolation layer 12 provided between the second and third active patterns AP2 and AP3.

The first and second device isolation layers 11 and 12 may include a dielectric material. For example, the first and second device isolation layers 11 and 12 may include silicon oxide.

First channel structures CH1 that overlap in the third direction D3 with the first active pattern AP1 may be formed, second channel structures CH2 that overlap in the third direction D3 with the second active pattern AP2 may be formed, third channel structures CH3 that overlap in the third direction D3 with the third active pattern AP3 may be formed, and fourth channel structures CH4 that overlap in the third direction D3 with the fourth active pattern AP4 may be formed.

Ones of the channel structures CH1, CH2, CH3, and CH4 that overlap in the third direction D3 with one of the active patterns AP 1, AP2, AP3, and AP4 may be arranged in the second direction D2. For example, the first channel structures CH1 that overlap in the third direction D3 with the first active pattern AP1 may be arranged in the second direction D2. Ones of the channel structures CH1, CH2, CH3, and CH4 that overlap in the third direction D3 with one of the active patterns AP1, AP2, AP3, and AP4 may be spaced apart from each other in the second direction D2. For example, the first channel structures CH1 that overlap in the third direction D3 with the first active pattern AP1 may be spaced apart from each other in the second direction D2.

The first channel structures CH1 may each include first semiconductor patterns SP1 that are arranged in the third direction D3. The first semiconductor patterns SP1 may be spaced apart from each other in the third direction D3. The second channel structures CH2 may each include second semiconductor patterns SP2 that are arranged in the third direction D3. The second semiconductor patterns SP2 may be spaced apart from each other in the third direction D3. The third channel structures CH3 may each include third semiconductor patterns SP3 that are arranged in the third direction D3. The third semiconductor patterns SP3 may be spaced apart from each other in the third direction D3. The fourth channel structures CH4 may each include fourth semiconductor patterns SP4 that are arranged in the third direction D3. The fourth semiconductor patterns SP4 may be spaced apart from each other in the third direction D3.

The number of the semiconductor patterns SP1, SP2, SP3, or SP4 included in one channel structure CH1, CH2, CH3, or CH4 may not be limited to that shown. In some embodiments, the number of the semiconductor patterns SP1, SP2, SP3, or SP4 included in one channel structure CH1, CH2, CH3, or CH4 may be equal to or less than 3 or equal to or greater than 5.

In some embodiments, the first, second, third, and fourth semiconductor patterns SP1, SP2, SP3, and SP4 may include silicon (Si). For example, the first, second, third, and fourth semiconductor patterns SP1, SP2, SP3, and SP4 may include crystalline silicon.

First lower source/drain patterns LSD1 may be provided on the first active pattern AP1. A lower portion of the first lower source/drain pattern LSD1 may be provided in the first active pattern AP1. Second lower source/drain patterns LSD2 may be provided on the second active pattern AP2. A lower portion of the second lower source/drain pattern LSD2 may be provided in the second active pattern AP2. Third lower source/drain patterns LSD3 may be provided on the third active pattern AP3. A lower portion of the third lower source/drain pattern LSD3 may be provided in the third active pattern AP3. Fourth lower source/drain patterns LSD4 may be provided on the fourth active pattern AP4. A lower portion of the fourth lower source/drain pattern LSD4 may be provided in the fourth active pattern AP4.

The first, second, third, and fourth lower source/drain patterns LSD1, LSD2, LSD3, and LSD4 may be an epitaxial pattern formed by a selective epitaxial growth process. The first, second, third, and fourth lower source/drain patterns LSD1, LSD2, LSD3, and LSD4 may include, for example, silicon (Si) or silicon-germanium (SiGe).

First upper source/drain patterns USD1 may be provided to overlap in the third direction D3 with the first active pattern AP1. The first upper source/drain pattern USD1 may be disposed between the first channel structures CH1 that are adjacent to each other in the second direction D2. The first upper source/drain pattern USD1 may be connected to the first semiconductor patterns SP1 of the first channel structure CH1. Second upper source/drain patterns USD2 may be provided to overlap in the third direction D3 with the second active pattern AP2. The second upper source/drain pattern USD2 may be disposed between the second channel structures CH2 that are adjacent to each other in the second direction D2. Third upper source/drain patterns USD3 may be provided to overlap in the third direction D3 with the third active pattern AP3. The third upper source/drain pattern USD3 may be disposed between the third channel structures CH3 that are adjacent to each other in the second direction D2. Fourth upper source/drain patterns USD4 may be provided to overlap in the third direction D3 with the fourth active pattern AP4. The fourth upper source/drain pattern USD4 may be disposed between the fourth channel structures CH4 that are adjacent to each other in the second direction D2.

The first upper source/drain pattern USD1 may overlap in the third direction D3 with the first lower source/drain pattern LSD1. The second upper source/drain pattern USD2 may overlap in the third direction D3 with the second lower source/drain pattern LSD2. The third upper source/drain pattern USD3 may overlap in the third direction D3 with the third lower source/drain pattern LSD3. The fourth upper source/drain pattern USD4 may overlap in the third direction D3 with the fourth lower source/drain pattern LSD4.

The first, second, third, and fourth upper source/drain patterns USD1, USD2, USD3, and USD4 may be an epitaxial pattern formed by a selective epitaxial growth process. The first, second, third, and fourth upper source/drain patterns USD1, USD2, USD3, and USD4 may include, for example, silicon (Si) or silicon-germanium (SiGe).

In some embodiments, the first and second lower source/drain patterns LSD1 and LSD2 and the first and second upper source/drain patterns USD1 and USD2 may be doped with impurities to have a first conductivity type, and the third and fourth lower source/drain patterns LSD3 and LSD4 and the third and fourth upper source/drain patterns USD3 and USD4 may be doped with impurities to have a second conductivity type different from the first conductivity type. For example, the first conductivity type may be p-type, and the second conductivity type may be n-type.

First gate electrodes GE1 may be provided to overlap in the third direction D3 with the first active pattern AP1. The first gate electrode GE1 may overlap in the third direction D3 with the first channel structure CH1. Second gate electrodes GE2 may be provided to overlap in the third direction D3 with the second active pattern AP2. The second gate electrode GE2 may overlap in the third direction D3 with the second channel structure CH2. Third gate electrodes GE3 may be provided to overlap in the third direction D3 with the third active pattern AP3. The third gate electrode GE3 may overlap in the third direction D3 with the third channel structure CH3. Fourth gate electrodes GE4 may be provided to overlap in the third direction D3 with the fourth active pattern AP4. The fourth gate electrode GE4 may overlap in the third direction D3 with the fourth channel structure CH4.

The first gate electrode GE1 may be disposed between the first upper source/drain patterns USD1 that are adjacent to each other in the second direction D2. The second gate electrode GE2 may be disposed between the second upper source/drain patterns USD2 that are adjacent to each other in the second direction D2. The third gate electrode GE3 may be disposed between the third upper source/drain patterns USD3 that are adjacent to each other in the second direction D2. The fourth gate electrode GE4 may be disposed between the fourth upper source/drain patterns USD4 that are adjacent to each other in the second direction D2. In some embodiments, a gate separation structure may be provided to separate the second gate electrode GE2 and the third gate electrode GE3 from each other.

The first, second, third, and fourth gate electrodes GE1, GE2, GE3, and GE4 and the first, second, third, and fourth semiconductor patterns SP1, SP2, SP3, and SP4 may constitute a three-dimensional field effect transistor (e.g., NMCFET or GAAFET). A conductive material included in the first and second gate electrodes GE1 and GE2 may be different from that included in the third and fourth gate electrodes GE3 and GE4.

A first lower dielectric pattern 61 may be provided between the first active pattern AP1 and the first channel structure CH1. A second lower dielectric pattern 62 may be provided between the second active pattern AP2 and the second channel structure CH2. A third lower dielectric pattern 63 may be provided between the third active pattern AP3 and the third channel structure CH3. A fourth lower dielectric pattern 64 may be provided between the fourth active pattern AP4 and the fourth channel structure CH4.

The first lower dielectric pattern 61 may surround upper portions of the first lower source/drain patterns LSD1. The second lower dielectric pattern 62 may surround upper portions of the second lower source/drain patterns LSD2. The third lower dielectric pattern 63 may surround upper portions of the third lower source/drain patterns LSD3. The fourth lower dielectric pattern 64 may surround upper portions of the fourth lower source/drain patterns LSD4.

The first lower dielectric pattern 61 may be in contact with a top surface of the first active pattern AP1. The second lower dielectric pattern 62 may be in contact with a top surface of the second active pattern AP2. The third lower dielectric pattern 63 may be in contact with a top surface of the third active pattern AP3. The fourth lower dielectric pattern 64 may be in contact with a top surface of the fourth active pattern AP4.

The first, second, third, and fourth lower dielectric patterns 61, 62, 63, and 64 may include a dielectric material. For example, each of the first, second, third, and fourth lower dielectric patterns 61, 62, 63, and 64 may include at least one selected from silicon carboxynitride, silicon oxide, silicon nitride, and silicon carbonitride.

Separation dielectric layers 20 may be provided. The separation dielectric layers 20 may extend in the second direction D2. The separation dielectric layers 20 may be spaced apart from each other in the first direction D1. One of the separation dielectric layers 20 may be disposed between the first and second gate electrodes GE1 and GE2, between the first and second channel structures CH1 and CH2, between the first and second upper source/drain patterns USD1 and USD2, between the first and second lower dielectric patterns 61 and 62, and between the first and second active patterns AP1 and AP2. Another of the separation dielectric layers 20 may be disposed between the third and fourth gate electrodes GE3 and GE4, between the third and fourth channel structures CH3 and CH4, between the third and fourth upper source/drain patterns USD3 and USD4, between the third and fourth lower dielectric patterns 63 and 64, and between the third and fourth active patterns AP3 and AP4.

The separation dielectric layer 20 may overlap in the third direction D3 with the first device isolation layer 11. The separation dielectric layer 20 may be in contact with the first device isolation layer 11. One of the separation dielectric layers 20 may be in contact with the first and second upper source/drain patterns USD1 and USD2. Another of the separation dielectric layers 20 may be in contact with the third and fourth upper source/drain patterns USD3 and USD4. The separation dielectric layer 20 may include a dielectric material different from that of the first and second isolation layers 11 and 12. For example, the separation dielectric layer 20 may include silicon nitride, and the first and second device isolation layers 11 and 12 may include silicon oxide.

Gate dielectric layers GI may be provided. The gate dielectric layers GI may separate the gate electrode GE1, GE2, GE3, and GE4 from the semiconductor patterns SP1, SP2, SP3, and SP4 of the channel structures CH1, CH2, CH3, and CH4. The gate dielectric layers GI may be in contact with the first device isolation layer 11, the second device isolation layer 12, the lower dielectric patterns 61, 62, 63, and 64, and the separation dielectric layer 20. The gate dielectric layers GI may include a dielectric material. For example, the gate dielectric layers GI may include silicon oxide.

Gate spacers GS may be provided. The gate spacers GS may be disposed on opposite sides of each of the gate electrode GE1, GE2, GE3, and GE4. The gate spacers GS may include a dielectric material. For example, the gate spacers GS may include silicon carboxynitride.

Gate capping patterns GP may be provided. The gate capping patterns GP may be provided on the first, second, third, and fourth gate electrodes GE1, GE2, GE3, and GE4. The gate capping patterns GP may include a dielectric material. For example, the gate capping patterns GP may include silicon nitride.

Lower cover dielectric layers 51 may be provided. The lower cover dielectric layers 51 may be in contact with the lower source/drain patterns LSD1, LSD2, LSD3, and LSD4, the lower dielectric patterns 61, 62, 63, and 64, the separation dielectric layer 20, the first device isolation layer 11, and the second device isolation layer 12. At least portions of the lower cover dielectric layers 51 may be disposed between the upper source/drain patterns USD1, USD2, USD3, and USD4 and the active patterns AP1, AP2, AP3, and AP4. The lower cover dielectric layers 51 may include a dielectric material.

Upper cover dielectric layers 52 may be provided. The upper cover dielectric layers 52 may be in contact with the upper source/drain patterns USD1, USD2, USD3, and USD4, the separation dielectric layer 20, and the lower cover dielectric layer 51. The upper cover dielectric layers 52 may include a dielectric material.

A dielectric layer 13 may be provided on the lower cover dielectric layer 51 and the upper cover dielectric layer 52. The dielectric layer 13 may include a dielectric material.

Active contacts 41 may be provided. The active contacts 41 may penetrate the dielectric layer 13 to come into contact with the upper source/drain patterns USD1, USD2, USD3, and USD4. The active contacts 41 may include a conductive material.

Gate contacts 45 may be provided. The gate contacts 45 may penetrate the gate capping patterns GP to come into connection with the gate electrodes GE1, GE2, GE3, and GE4. The gate contacts 45 may include a conductive material.

Referring to FIGS. 1B and 1C, a width W1 in the first direction D1 of the separation dielectric layer 20 may be less than the width in the first direction D1 of the first device isolation layer 11. The width W1 in the first direction D1 of the separation dielectric layer 20 may be, for example, about 1.8 times to about 3 times a distance in the first direction D1 between the first semiconductor pattern SP1 and the separation dielectric layer 20. The width W1 in the first direction D1 of the separation dielectric layer 20 may range, for example, from about 15 nm to about 20 nm. The distance in the first direction D1 between the first semiconductor pattern SP1 and the separation dielectric layer 20 may range, for example, about 5 nm to about 11 nm. Each of the first, second, third, and fourth upper source/drain patterns USD1, USD2, USD3, and USD4 may be in contact with a lateral surface 20_S of the separation dielectric layer 20.

Referring to FIGS. 1C, 1E, and 1G, the first device isolation layer 11 may include a first part 11_1 and second parts 11_2. The first part 11_1 of the first device isolation layer 11 may be located at a lower level than that of the second parts 11_2 of the first device isolation layer 11. The second parts 11_2 of the first device isolation layer 11 may protrude in the third direction D3 from the first part 11_1 of the first device isolation layer 11. The second parts 11_2 of the first device isolation layer 11 may be arranged along the second direction D2. The second parts 11_2 of the first device isolation layer 11 may be spaced apart from each other in the second direction D2. The first part 11_1 of the first device isolation layer 11 may have a width in the second direction D2 greater than a width in the second direction D2 of the second part 11_2 of the first device isolation layer 11.

The first device isolation layer 11 may have first top surfaces 11_T1 and second top surfaces 11_T2. The first top surface 11_T1 of the first device isolation layer 11 may be located at a higher level than that of the second top surface 1 1_T2 of the first device isolation layer 11. A distance in the third direction D3 between the first top surface 11_T1 of the first device isolation layer 11 and a bottom surface of the first device isolation layer 11 may be greater than a distance in the third direction D3 between the second top surface 11_T2 of the first device isolation layer 11 and the bottom surface of the first device isolation layer 11.

The first top surface 11_T1 of the first device isolation layer 11 may be in contact with the gate dielectric layer GI. The second top surface 11_T2 of the first device isolation layer 11 may be in contact with the lower cover dielectric layer 51. The first top surface 11_T1 of the first device isolation layer 11 may be a top surface of the second part 11_2 of the first device isolation layer 11.

The first and second top surfaces 11_T1 and 11_T2 of the first device isolation layer 11 may be located at their levels higher than that of a top surface 12_T of the second device isolation layer 12. The distance in the third direction D3 between the first top surface 11_T1 of the first device isolation layer 11 and the bottom surface of the first device isolation layer 11 and the distance in the third direction D3 between the second top surface 11_T2 of the first device isolation layer 11 and the bottom surface of the first device isolation layer 11 may be greater than a distance in the third direction D3 between the top surface 12_T of the second device isolation layer 12 and a bottom surface of the second device isolation layer 12.

The first top surface 11_T1 of the first device isolation layer 11, the second top surface 11_T2 of the first device isolation layer 11, and the top surface 12_T of the second device isolation layer 12 may be located at their levels higher than that of a bottom surface 20_B of the separation dielectric layer 20. The distance in the third direction D3 between the first top surface 11_T1 of the first device isolation layer 11 and the bottom surface of the first device isolation layer 11, the distance in the third direction D3 between the second top surface 1 1_T2 of the first device isolation layer 11 and the bottom surface of the first device isolation layer 11, and the distance in the third direction D3 between the top surface 12_T of the second device isolation layer 12 and a bottom surface of the second device isolation layer 12 may be greater than a distance in the third direction D3 between the bottom surface 20_B of the separation dielectric layer 20 and the bottom surface of the first device isolation layer 11.

The first top surfaces 11_T1 of the first device isolation layer 11 may overlap in the third direction D3 with the gate electrodes GE1, GE2, GE3, and GE4. The second top surfaces 11_T2 of the first device isolation layer 11 may overlap in the third direction D3 with the upper source/drain patterns USD1, USD2, USD3, and USD4.

The bottom surface 20_B of the separation dielectric layer 20 may be located at a higher level than that of the bottom surface of the first device isolation layer 11 and that of the bottom surface of the second device isolation layer 12.

Referring to FIG. 1G, the first gate electrode GE1 may include first parts GE1_1, a second part GE1_2, a third part GE1_3, and a fourth part GE1_4. The first part GE1_1 of the first gate electrode GE1 may be disposed between the first semiconductor patterns SP1 or between the first semiconductor pattern SP1 and the first lower dielectric pattern 61. The second part GE1_2 of the first gate electrode GE1 may be disposed between the separation dielectric layer 20 and the first semiconductor patterns SP1. The second part GE1_2 of the first gate electrode GE1 may overlap in the third direction D3 with the first device isolation layer 11. The third part GE1_3 of the first gate electrode GE1 may overlap in the third direction D3 with the second device isolation layer 12.

The second part GE1_2 and the third part GE1_3 of the first gate electrode GE1 may be connected to opposite sides of each of the first parts GE1_1 of the first gate electrode GE1. The fourth part GE1_4 of the first gate electrode GE1 may be located at a higher level than those of the first semiconductor patterns SP1. The fourth part GE1_4 of the first gate electrode GE1 may be connected to the second part GE1_2 and the third part GE1_3 of the first gate electrode GE1.

Similar to the first gate electrode GE1, each of the second, third, and fourth gate electrodes GE2, GE3, and GE4 may include first parts, a second part, a third part, and a fourth part.

A semiconductor device according to some embodiments may include a part interposed between the separation dielectric layer 20 and semiconductor patterns, and thus it may be possible to include a three-dimensional field effect transistor and to have a relative advantage of channel control.

A semiconductor device according to some embodiments may include a part interposed between the separation dielectric layer 20 and semiconductor patterns, and thus the semiconductor patterns may have a relatively uniform width, and there may be a relative reduction in distribution of current that flows through the semiconductor patterns.

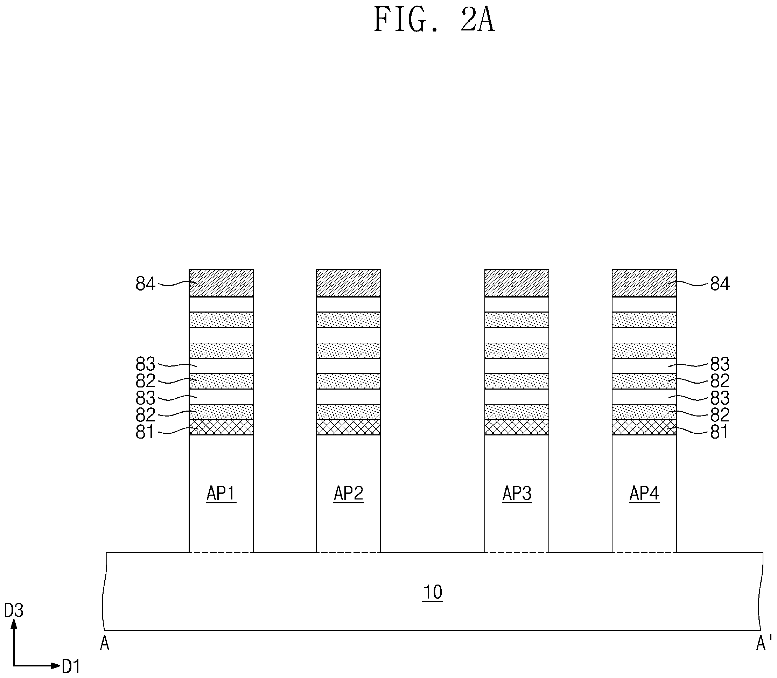

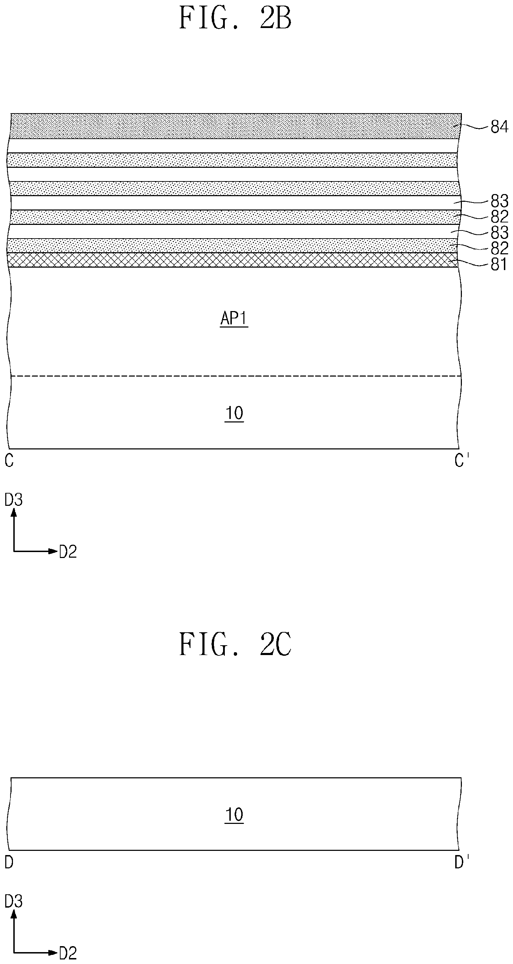

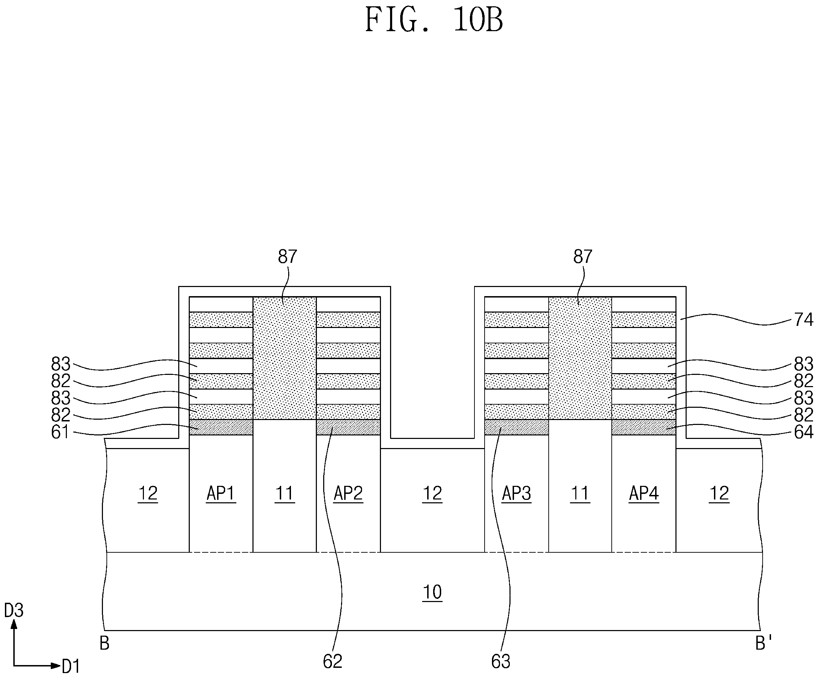

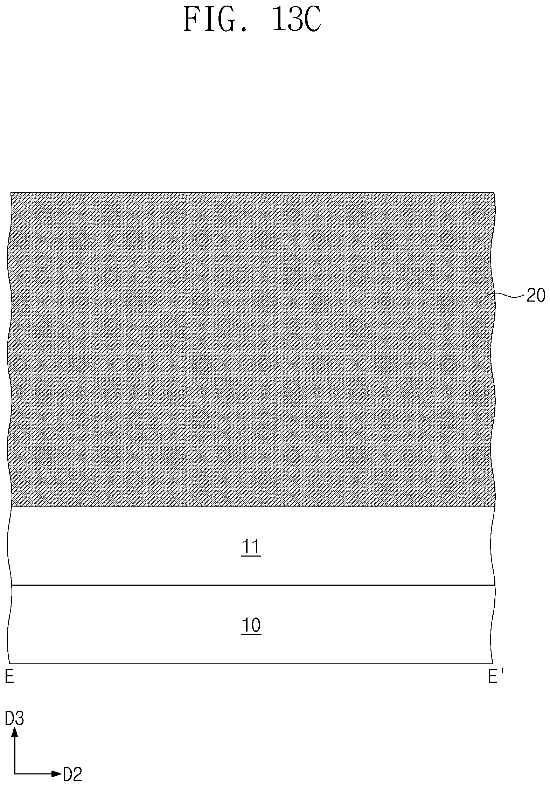

FIGS. 2A, 2B, 2C, 3, 4, 5, 6A, 6B, 6C, 7, 8A, 8B, 9, 10A, 10B, 10C, 10D, 11A, 11B, 11C, 11D, 12A, 12B, 12C, 12D, 13A, 13B, 13C, 14A, 14B, 14C, 15A, 15B, and 15C illustrate cross-sectional views showing a method of fabricating a semiconductor device according to some embodiments. FIGS. 2A, 3, 4, 5, 6A, 7, 8A, 9, 10A, 11A, 12A, 13A, and 15A may correspond to FIG. 1B. FIGS. 10B, 11B, 12B, 13B, and 14A may correspond to FIG. 1C. FIGS. 2B, 6B, 10C, 11C, 12C, 14B, and 15B may correspond to FIG. 1D. FIGS. 2C, 6C, 8B, 10D, 11D, 12D, 14C, and 15C may correspond to FIG. 1E. FIG. 13C may correspond to FIG. 1F.

Referring to FIGS. 2A, 2B, and 2C, active patterns AP1, AP2, AP3, and AP4, first semiconductor layers 81, second semiconductor layers 82, third semiconductor layers 83, and mask patterns 84 may be formed. The first semiconductor layers 81 may be formed on the active pattern AP1, AP2, AP3, and AP4. The second semiconductor layers 82 and the third semiconductor layers 83 may be alternately formed along a third direction D3 on the first semiconductor layers 81. The mask pattern 84 may be formed on the third semiconductor layers 83.

The first and second semiconductor layers 81 and 82 may include a material having an etch selectivity with respect to the third semiconductor layer 83. For example, the first and second semiconductor layers 81 and 82 may include silicon-germanium (SiGe), and the third semiconductor layer 83 may include silicon (Si).

The first semiconductor layer 81 may have a germanium (Ge) concentration different from that of the second semiconductor layer 82. For example, the germanium concentration of the first semiconductor layer 81 may be greater than that of the second semiconductor layer 82. The mask pattern 84 may include a dielectric material. For example, the mask pattern 84 may include silicon nitride.

The formation of the active patterns AP1, AP2, AP3, and AP4, the first semiconductor layers 81, the second semiconductor layers 82, the third semiconductor layers 83, and the mask patterns 84 may include forming preliminary semiconductor layers on a substrate 10, forming a preliminary mask pattern layer on the preliminary semiconductor layers, patterning the preliminary mask pattern layer to form the mask patterns 84, and using the mask patterns 84 to pattern the preliminary semiconductor layers and the substrate 10. The substrate 10 may be patterned to form the active patterns AP1, AP2, AP3, and AP4. The preliminary semiconductor layers may be patterned to form the semiconductor layers 81, 82, and 83.

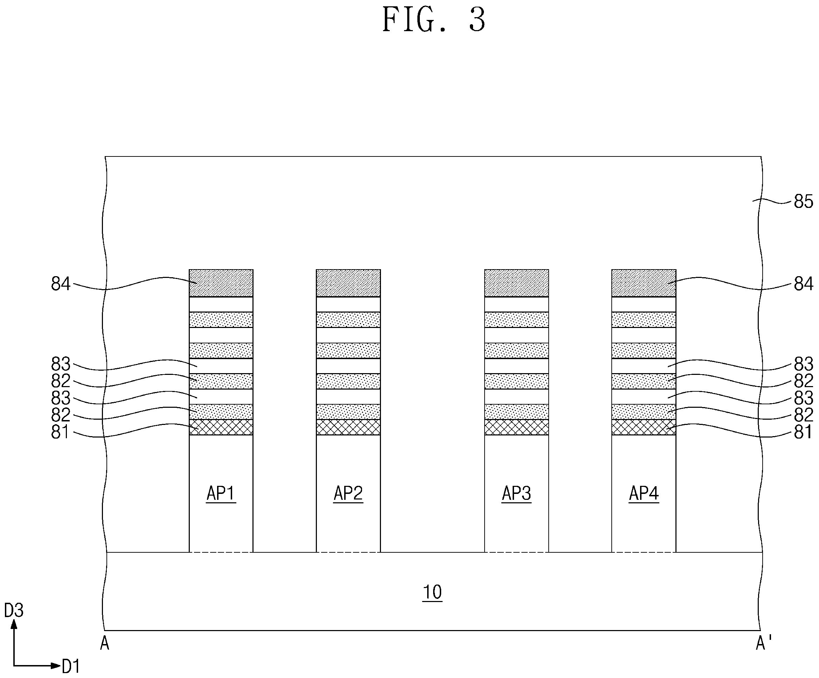

Referring to FIG. 3, a preliminary separation layer 85 may be formed. The preliminary separation layer 85 may cover the active patterns AP1, AP2, AP3, and AP4, the first semiconductor layers 81, the second semiconductor layers 82, the third semiconductor layers 83, and the mask patterns 84. The preliminary separation layer 85 may include a dielectric material. For example, the preliminary separation layer 85 may include silicon oxide.

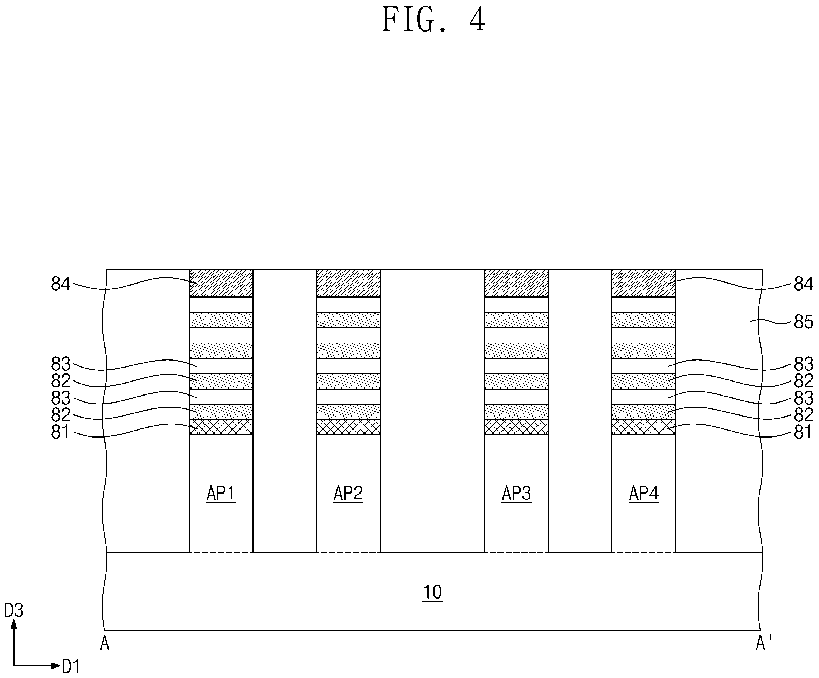

Referring to FIG. 4, an upper portion of the preliminary separation layer 85 may be removed. For example, the upper portion of the preliminary separation layer 85 may be removed by a chemical mechanical polishing process. The upper portion of the preliminary separation layer 85 may be removed to expose the mask patterns 84.

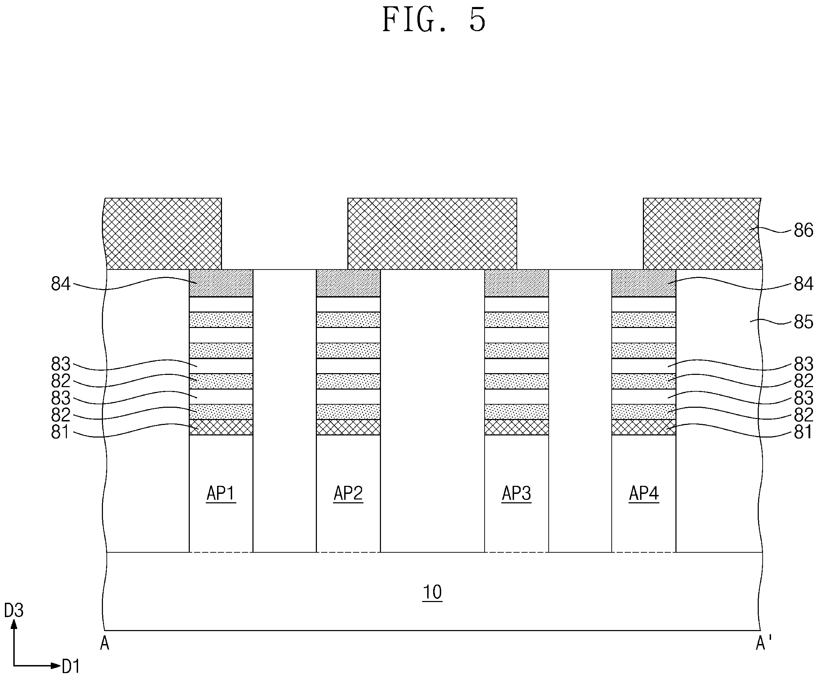

Referring to FIG. 5, a photoresist pattern 86 may be formed. The formation of the photoresist pattern 86 may include forming a photoresist layer on the preliminary separation layer 85 and the mask patterns 84, and patterning the photoresist layer to form the photoresist pattern 86. The photoresist pattern 86 may include a photoresist material. The photoresist pattern 86 may expose portions of the preliminary separation layer 85.

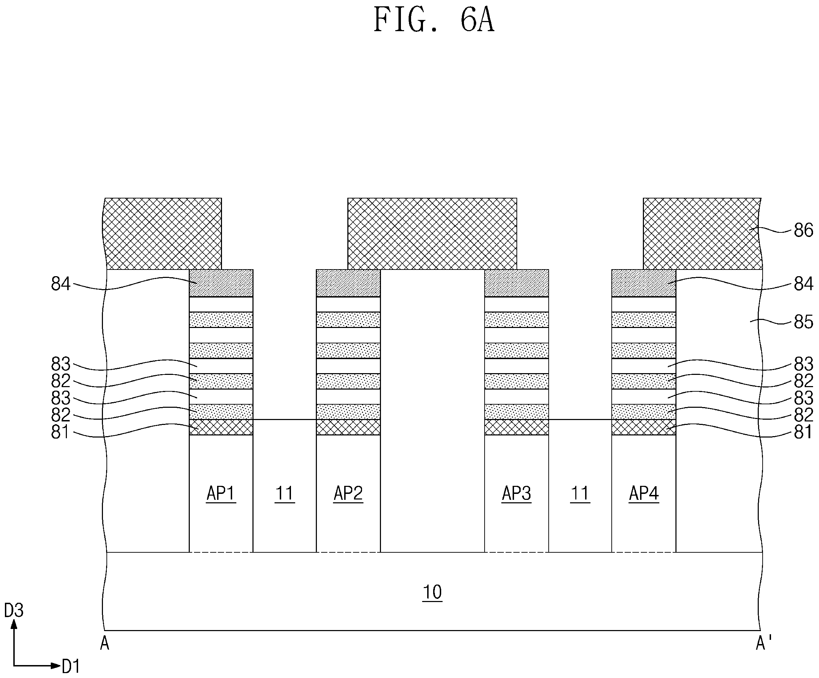

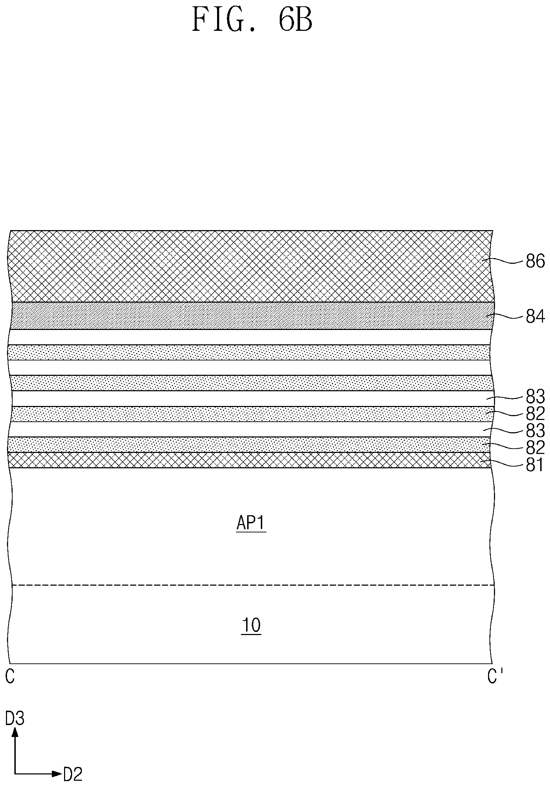

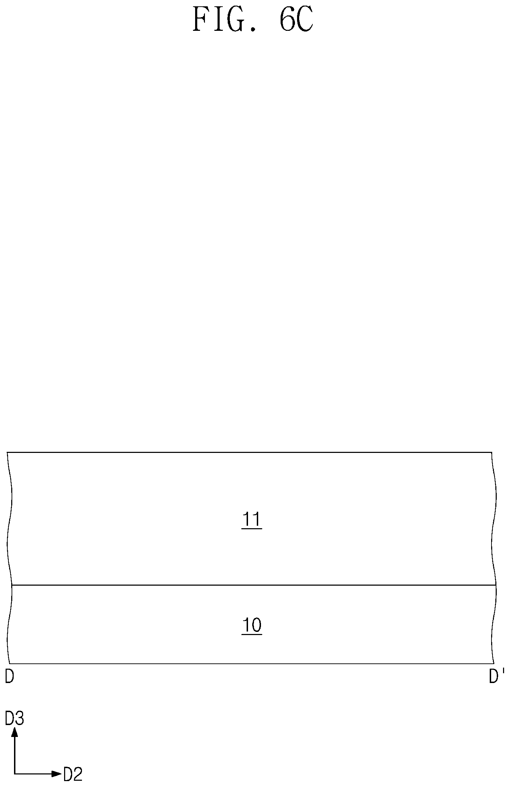

Referring to FIGS. 6A, 6B, and 6C, first device isolation layers 11 may be formed. The portions of the preliminary separation layer 85 exposed by the photoresist pattern 86 may be etched to form the first device isolation layers 11.

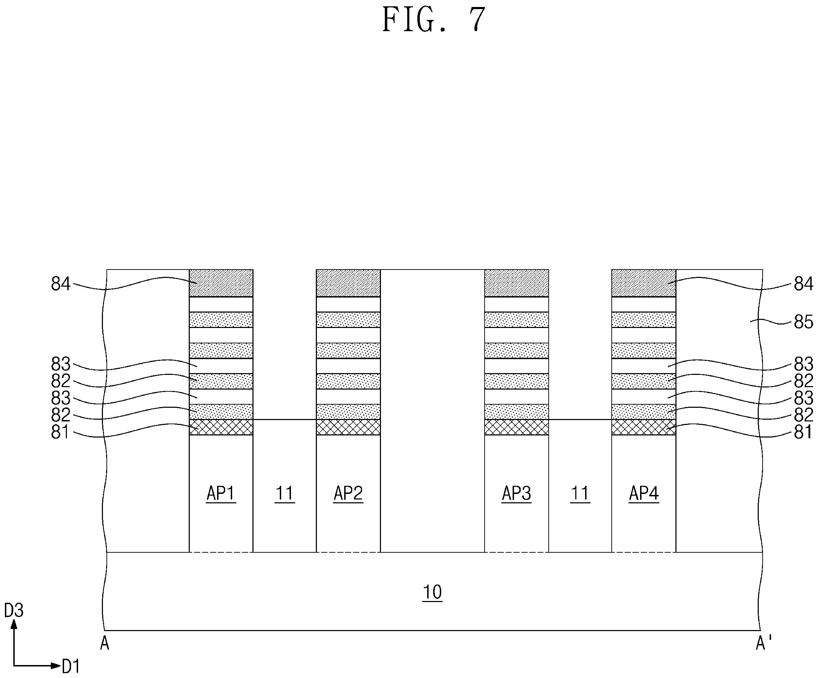

Referring to FIG. 7, the photoresist pattern 86 may be removed. For example, the photoresist pattern 86 may be removed by using at least one selected from an ashing process and a strip process.

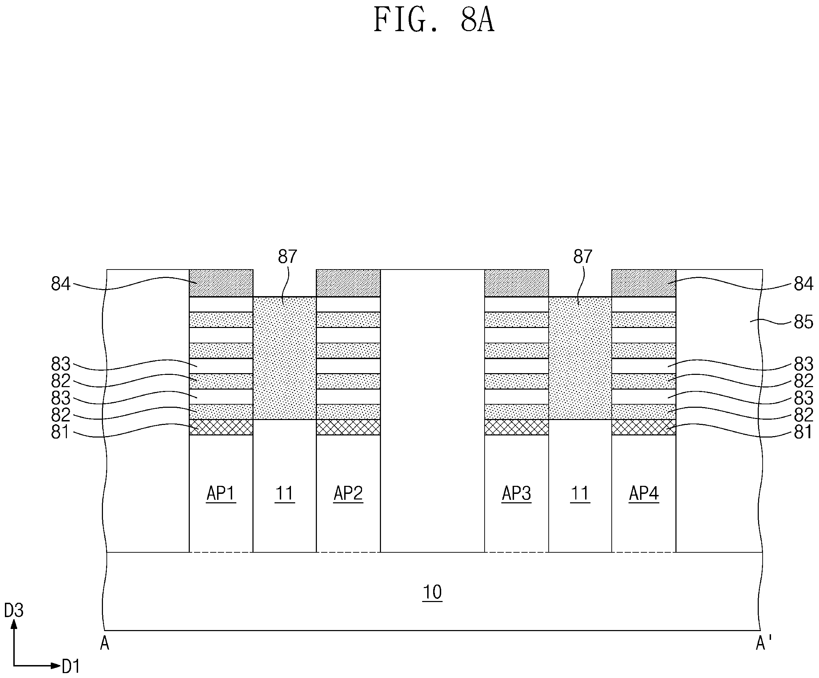

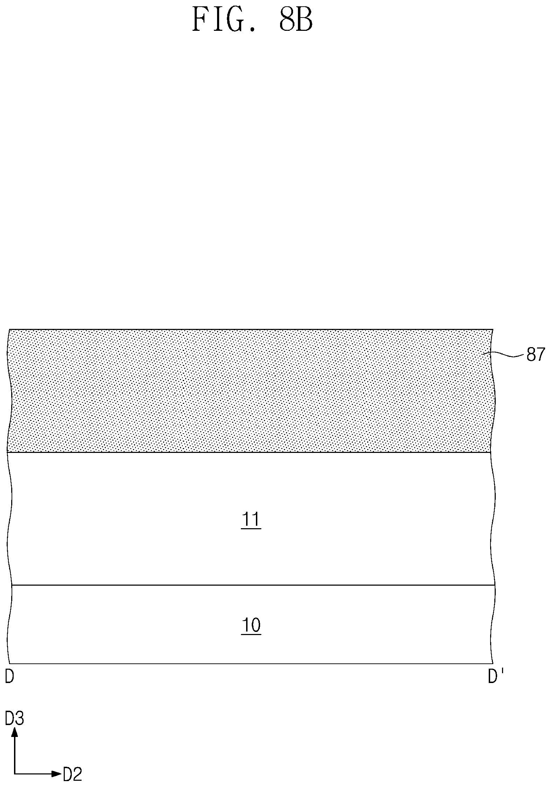

Referring to FIGS. 8A and 8B, sacrificial layers 87 may be formed. The sacrificial layer 87 may extend in a second direction D2. One of the sacrificial layers 87 may be formed between the second and third semiconductor layers 82 and 83 that overlap in the third direction D3 with the first active pattern AP1 and the second and third semiconductor layers 82 and 83 that overlap in the third direction D3 with the second active pattern AP2. Another of the sacrificial layers 87 may be formed between the second and third semiconductor layers 82 and 83 that overlap in the third direction D3 with the third active pattern AP3 and the second and third semiconductor layers 82 and 83 that overlap in the third direction D3 with the fourth active pattern AP4. The sacrificial layer 87 may overlap in the third direction D3 with the first device isolation layer 11. The sacrificial layer 87 may be formed in the first device isolation layer 11. The sacrificial layer 87 may be formed by an epitaxial growth process in which the second and third semiconductor layers 82 and 83 are used as seeds. In some embodiments, the sacrificial layer 87 may be formed by a deposition process and an etching process.

The sacrificial layer 87 may include silicon-germanium (SiGe). The sacrificial layer 87 may have a germanium (Ge) concentration of, for example, about 25 wt% to about 35 wt%. In some embodiments, the germanium concentration of the sacrificial layer 87 may be the same as that of the second semiconductor layer 82.

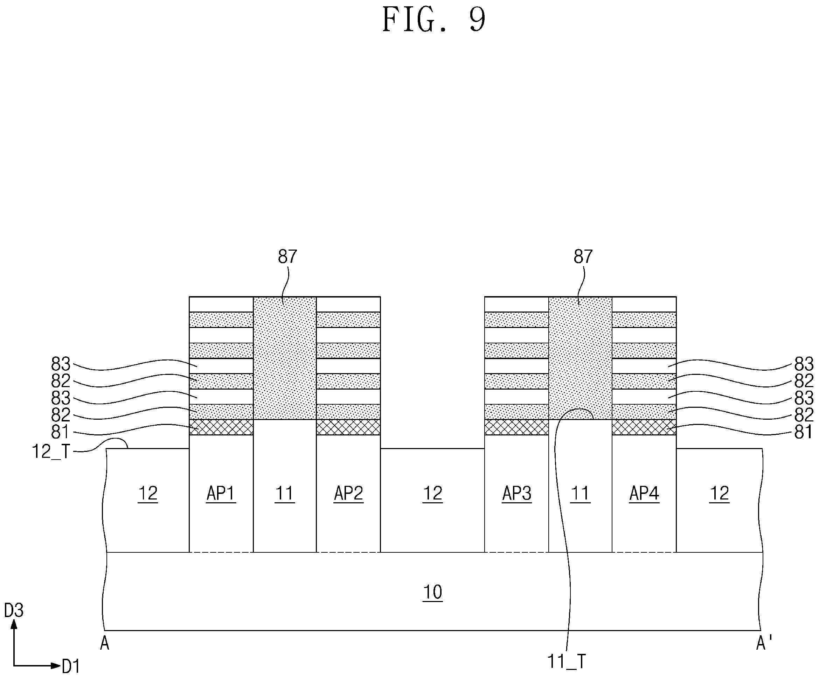

Referring to FIG. 9, second device isolation layers 12 may be formed. The preliminary separation layer 85 may be etched to form the second device isolation layers 12. As the sacrificial layer 87 is disposed on the first device isolation layer 11, the first device isolation layer 11 may not be etched in a process for forming the second device isolation layer 12. Therefore, a top surface 11_T of the first device isolation layer 11 may be located at a higher level than that of a top surface 12_T of the second device isolation layer 12. The mask patterns 84 may be removed.

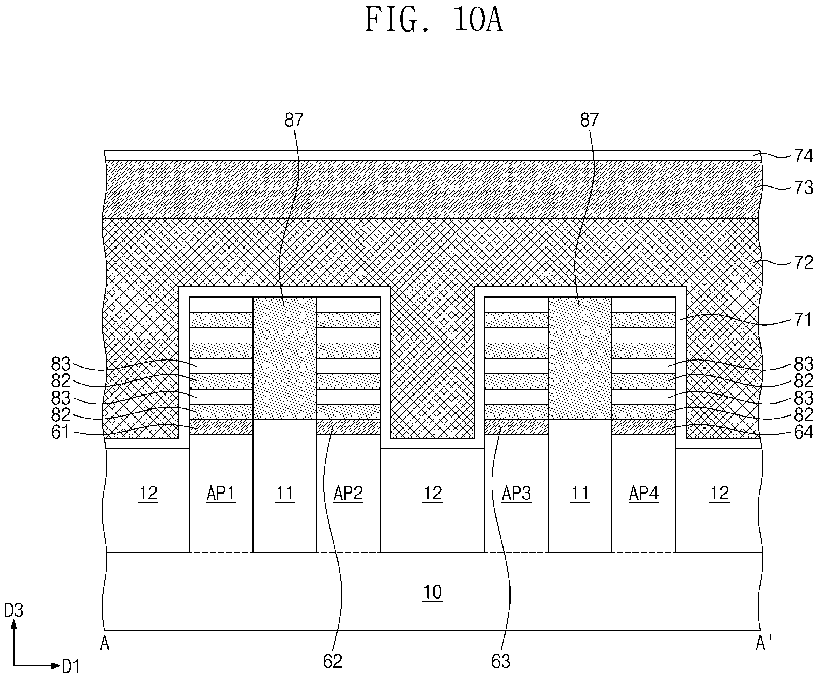

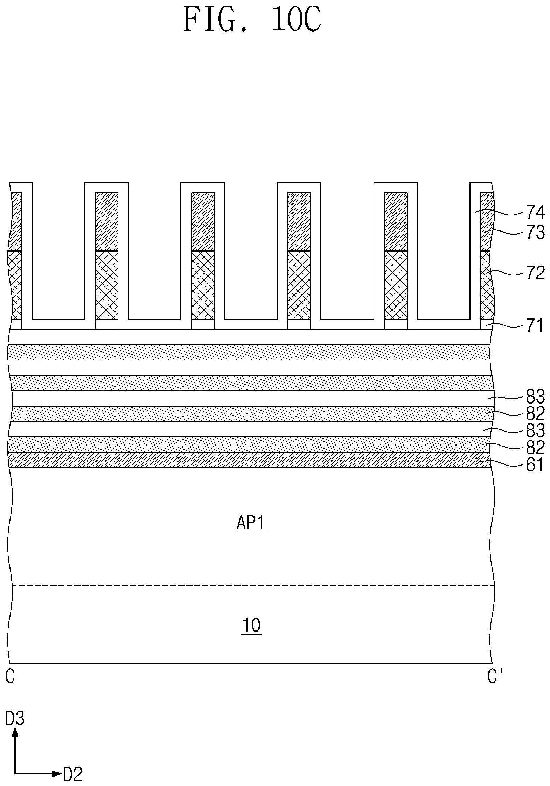

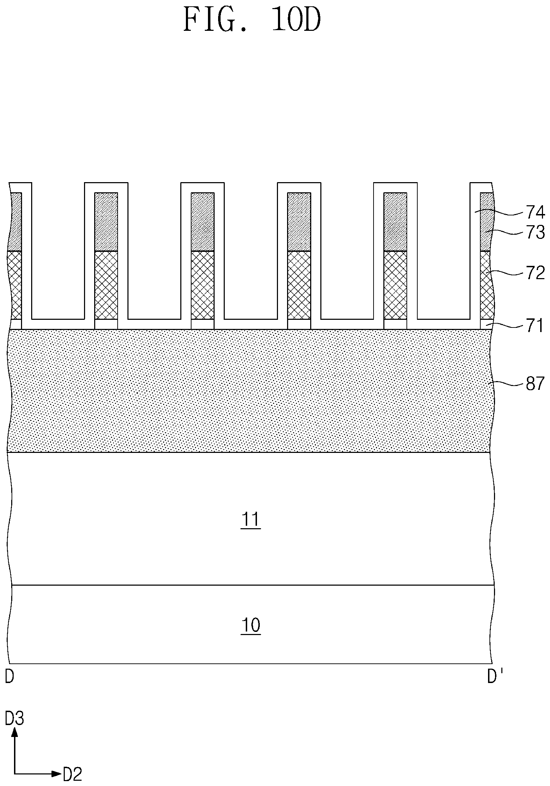

Referring to FIGS. 10A, 10B, 10C, and 10D, first, second, third, and fourth lower dielectric patterns 61, 62, 63, and 64 may be formed. The formation of the first, second, third, and fourth lower dielectric patterns 61, 62, 63, and 64 may include selectively removing the first semiconductor layers 81, and forming the first, second, third, and fourth lower dielectric patterns 61, 62, 63, and 64 in empty spaces formed by selectively removing the first semiconductor layers 81.

First gate sacrificial layers 71, second gate sacrificial layers 72, gate mask patterns 73, and a preliminary gate spacer layer 74 may be formed. The formation of the first gate sacrificial layers 71, the second gate sacrificial layers 72, the gate mask patterns 73, and the preliminary gate spacer layer 74 may include forming a first preliminary gate sacrificial layer on the second device isolation layers 12, the first, second, third, and fourth lower dielectric patterns 61, 62, 63, and 64, the second and third semiconductor layers 82 and 83, and the sacrificial layers 87, and forming a second preliminary gate sacrificial layer on the first preliminary gate sacrificial layer, forming a preliminary gate mask pattern layer on the second preliminary gate sacrificial layer, patterning the preliminary gate mask pattern layer to form the gate mask patterns 73, using the gate mask patterns 73 to pattern the first preliminary gate sacrificial layer and the second preliminary gate sacrificial layer to form the first gate sacrificial layers 71 and the second gate sacrificial layers 72, and forming the preliminary gate spacer layer 74 on the gate mask patterns 73, the first gate sacrificial layers 71, and the second gate sacrificial layers 72.

The first gate sacrificial layers 71, the second gate sacrificial layers 72, and the gate mask patterns 73 may extend in a first direction D1. The first gate sacrificial layers 71 may be arranged in the second direction D2. The second gate sacrificial layers 72 may be arranged in the second direction D2. The gate mask patterns 73 may be arranged in the second direction D2.

The first gate sacrificial layer 71 may include a dielectric material. For example, the first gate sacrificial layer 71 may include silicon oxide. The second gate sacrificial layer 72 may include, for example, polysilicon. The gate mask pattern 73 may include a dielectric material. For example, the gate mask pattern 73 may include silicon nitride. The preliminary gate spacer layer 74 may include a dielectric material. For example, the preliminary gate spacer layer 74 may include silicon carboxynitride.

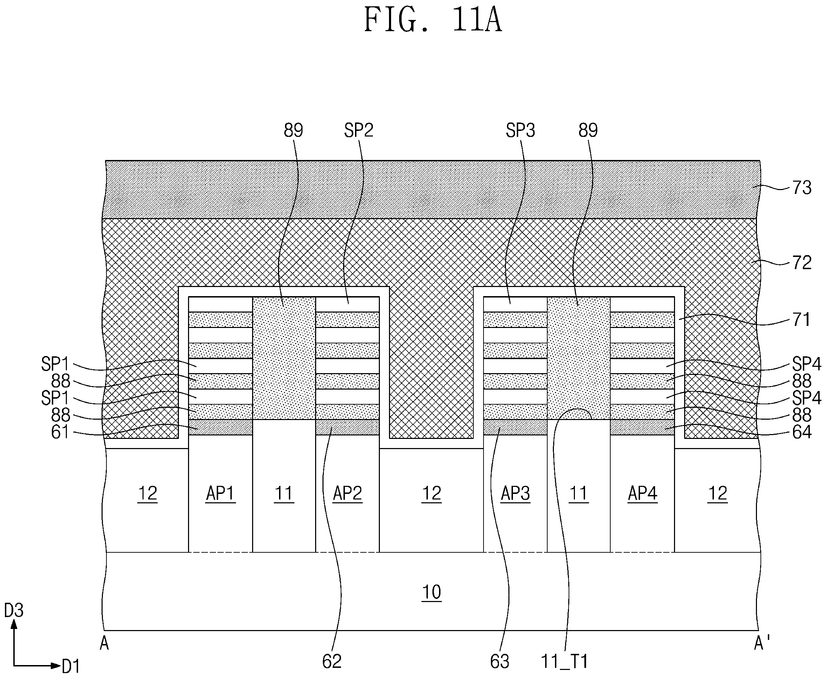

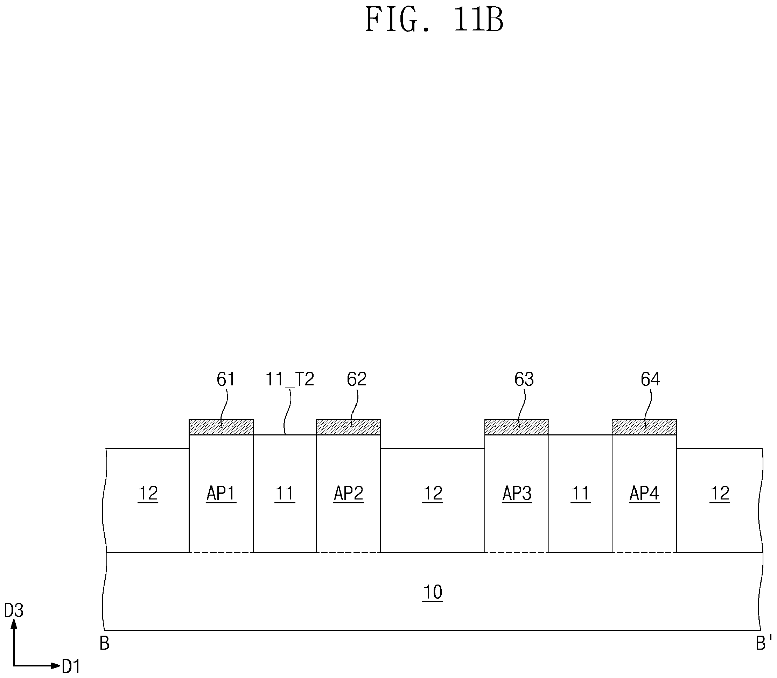

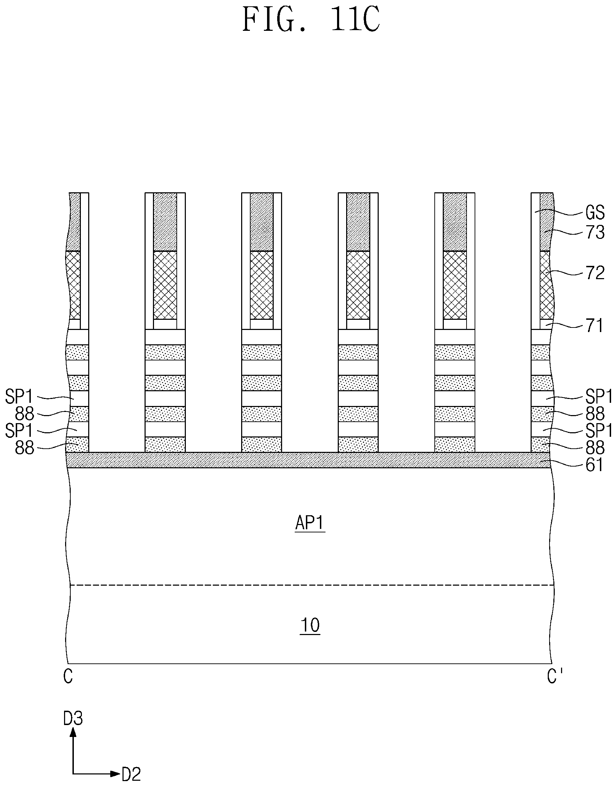

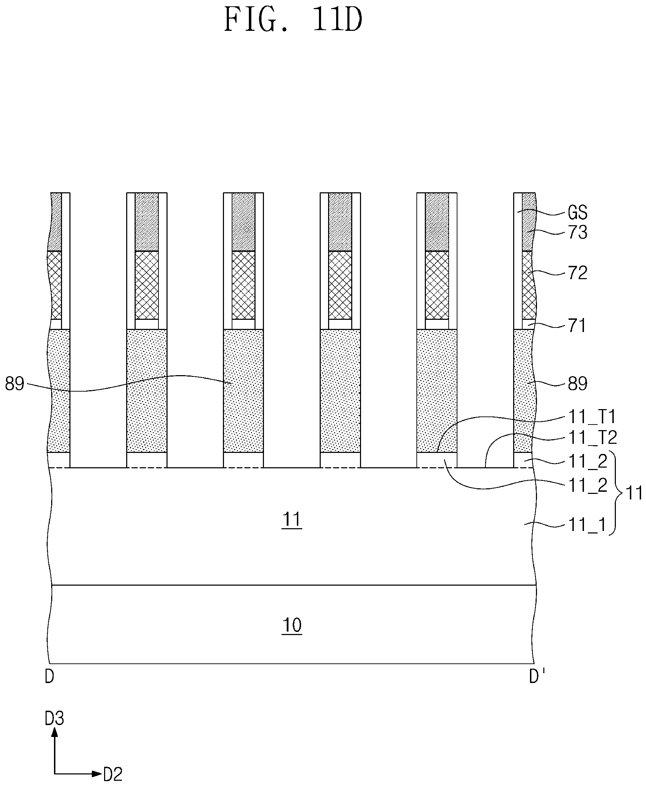

Referring to FIGS. 11A, 11B, 11C, and 11D, the preliminary gate spacer layer 74 may be etched. The etching of the preliminary gate spacer layer 74 may form gate spacers GS. The etching of the preliminary gate spacer layer 74 may expose the gate mask patterns 73. As a result of the etching of the preliminary gate spacer layer 74, the second and third semiconductor layers 82 and 83 and portions of the sacrificial layers 87 may be exposed through spaces between the gate spacers GS.

The second and third semiconductor layers 82 and 83 and the sacrificial layers 87 may be etched. There may be removed portions that overlap in the third direction D3 with spaces between the second and third semiconductor layers 82 and 83 and the gate spacers GS of the sacrificial layers 87. One second semiconductor layer 82 may be separated into a plurality of semiconductor sacrificial patterns 88. One third semiconductor layer 83 may be separated into a plurality of semiconductor patterns SP1, SP2, SP3, and SP4. One sacrificial layer 87 may be separated into a plurality of sacrificial patterns 89.

The first device isolation layer 11 may be etched together with the etching of the second and third semiconductor layers 82 and 83 and the sacrificial layers 87. As the sacrificial layer 87 is etched, a portion of the first device isolation layer 11 may be exposed between the sacrificial patterns 89, and a portion of the first device isolation layer 11 may be removed. The etching of the first device isolation layer 11 may define first top surfaces 11_T1 and second top surfaces 11_T2 of the first device isolation layer 11, and may also define a first part 11_1 and second parts 11_2 of the first device isolation layer 11.

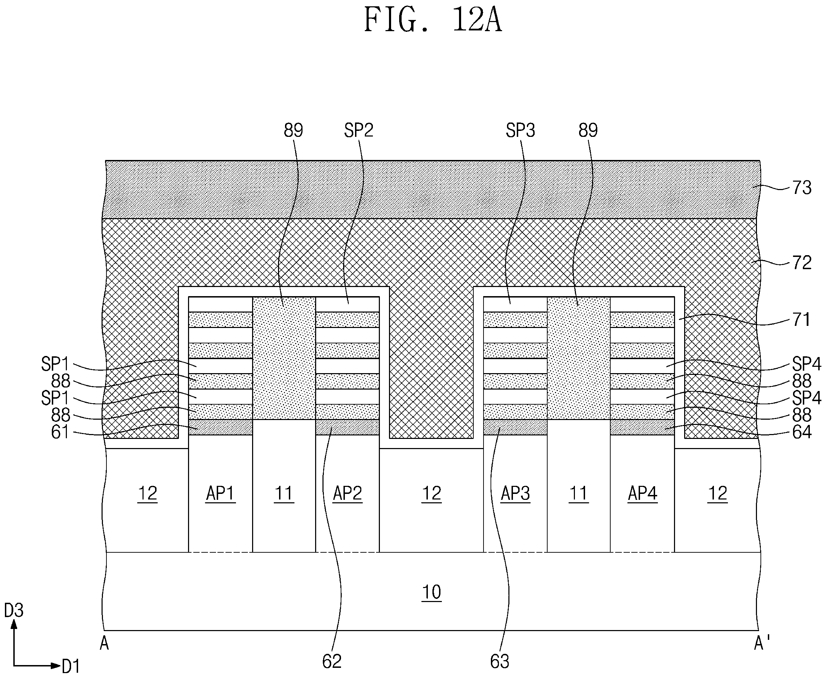

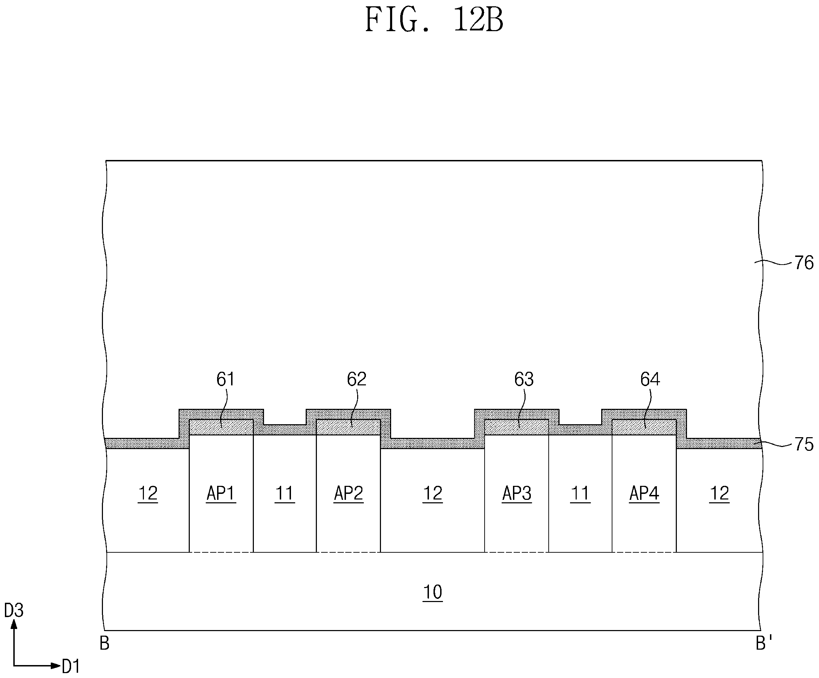

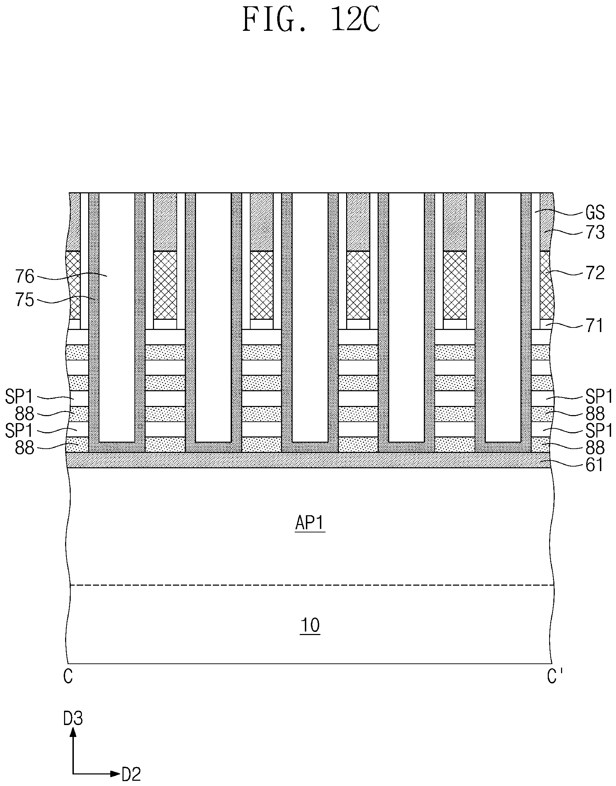

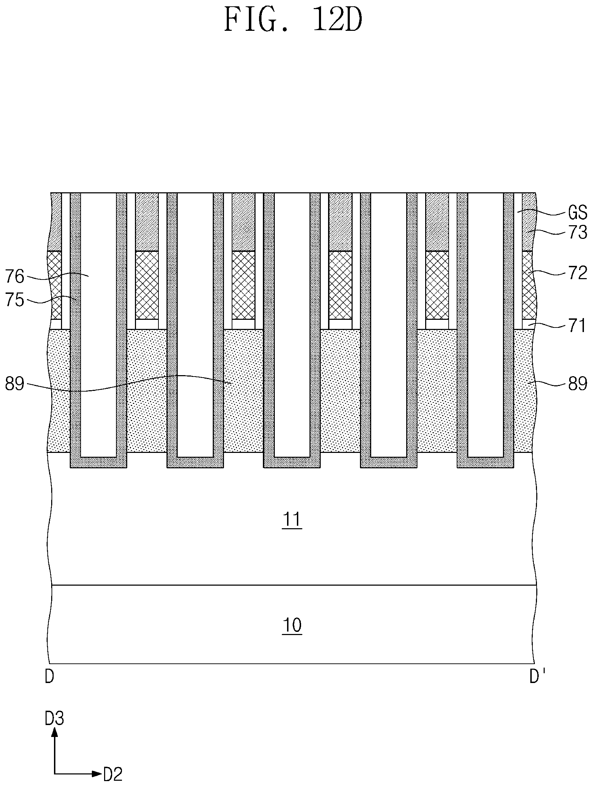

Referring to FIGS. 12A, 12B, 12C, and 12D, dielectric liners 75 may be formed. The dielectric liner 75 may be formed on the first and second device isolation layers 11 and 12, the first, second, third, and fourth lower dielectric patterns 61, 62, 63, and 64, the semiconductor patterns SP1, SP2, SP3, and SP4, the semiconductor sacrificial patterns 88, the sacrificial patterns 89, and the gate spacers GS. The dielectric liner 75 may include a dielectric material. For example, the dielectric liner 75 may include silicon nitride.

Gap-fill layers 76 may be formed. The gap-fill layer 76 may be formed on the dielectric liner 75. The gap-fill layer 76 may include a dielectric material. For example, the gap-fill layer 76 may include silicon oxide.

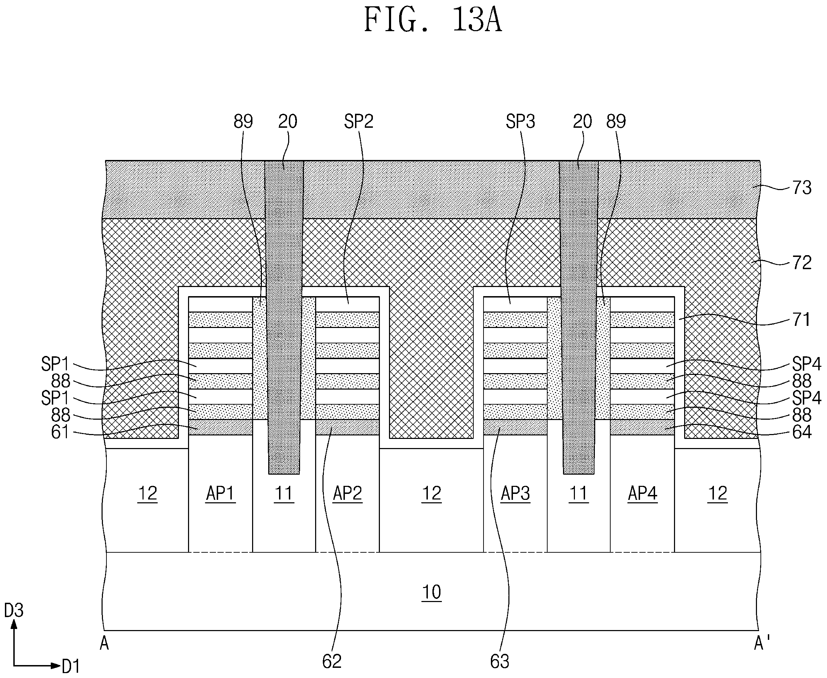

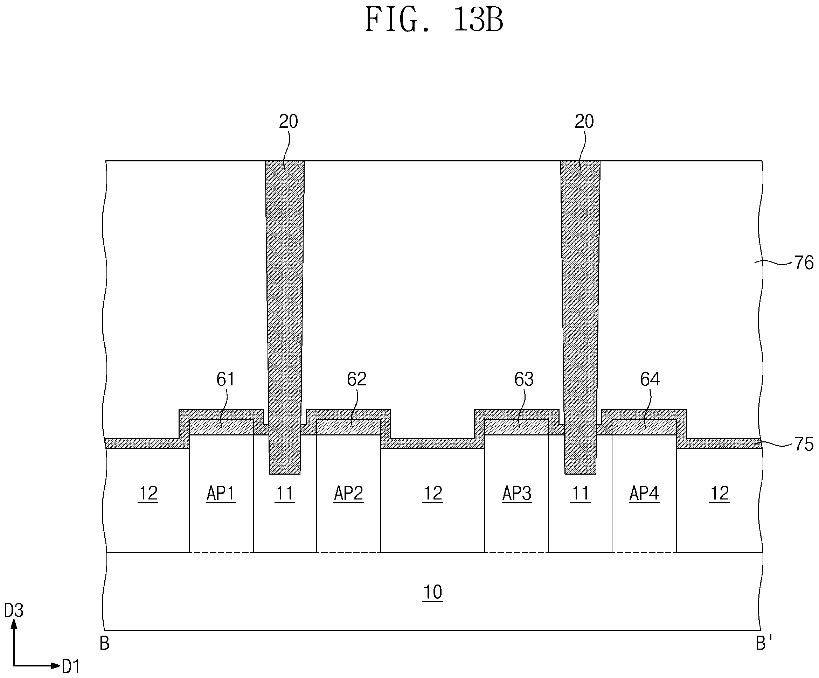

Referring to FIGS. 13A, 13B, and 13C, separation dielectric layers 20 may be formed. The separation dielectric layer 20 may penetrate the gate mask pattern 73, the second gate sacrificial layer 72, the first gate sacrificial layer 71, the sacrificial pattern 89, and the dielectric liner 75.

The formation of the separation dielectric layer 20 may include forming a trench that penetrates the gate mask pattern 73, the second gate sacrificial layer 72, the first gate sacrificial layer 71, the sacrificial pattern 89, and the dielectric liner 75, and forming the separation dielectric layer 20 that fills the trench. The formation of the separation dielectric layer 20 may separate one sacrificial pattern 89 into two sacrificial patterns 89. The two sacrificial patterns 89 may be in contact with the separation dielectric layer 20.

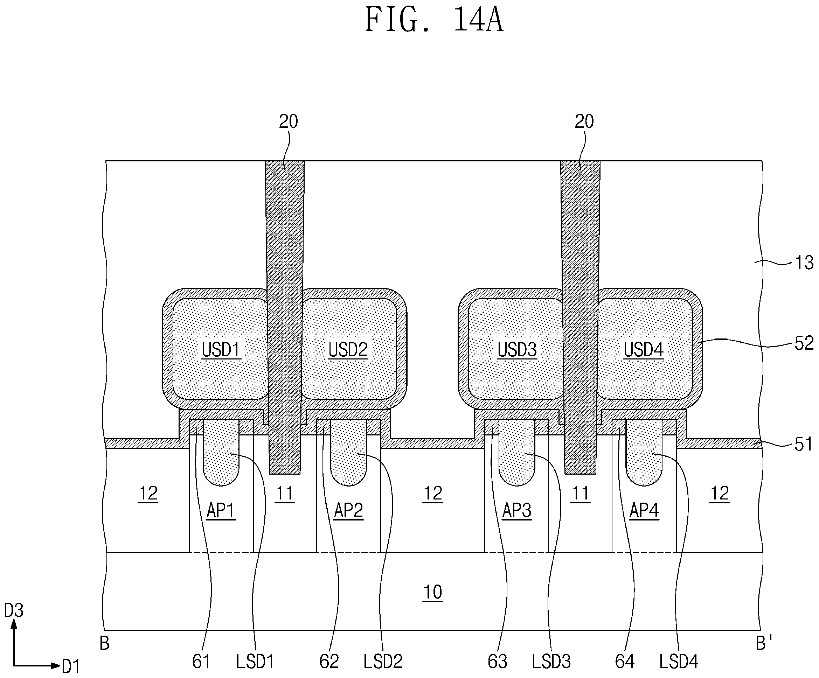

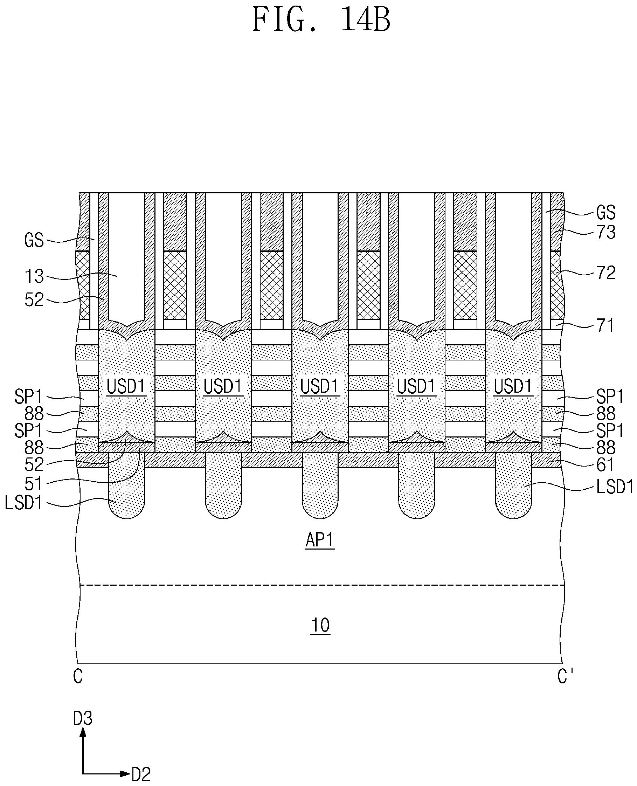

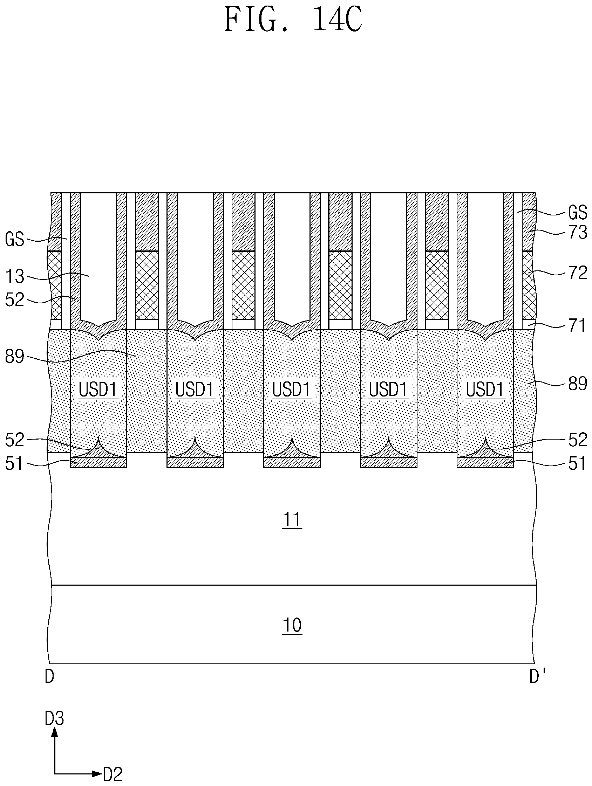

Referring to FIGS. 14A, 14B, and 14C, the gap-fill layer 76 and the dielectric liner 75 may be removed. First, second, third, and fourth lower source/drain patterns LSD1, LSD2, LSD3, and LSD4 may be formed. The formation of the lower source/drain patterns LSD1, LSD2, LSD3, and LSD4 may include forming holes by etching the lower dielectric patterns 61, 62, 63, and 64 and the active patterns AP1, AP2, AP3, and AP4, and epitaxially growing the lower source/drain patterns LSD1, LSD2, LSD3, and LSD4 from seeds or the active patterns AP1, AP2, AP3, and AP4 that are exposed through the holes.

Lower cover dielectric layers 51 may be formed. The formation of the lower cover dielectric layers 51 may include forming a preliminary lower cover dielectric layer on the first and second device isolation layers 11 and 12, the first, second, third, and fourth lower dielectric patterns 61, 62, 63, and 64, the first, second, third, and fourth semiconductor patterns SP1, SP2, SP3, and SP4, the semiconductor sacrificial patterns 88, and the sacrificial patterns 89, and etching the preliminary lower cover dielectric layer to expose the first, second, third, and fourth semiconductor patterns SP1, SP2, SP3, and SP4, the semiconductor sacrificial patterns 88, and the sacrificial patterns 89. The preliminary lower cover dielectric layer may be etched into the lower cover dielectric layers 51.

First, second, third, and fourth upper source/drain patterns USD1, USD2, USD3, and USD4 may be formed. The formation of the first, second, third, and fourth upper source/drain patterns USD1, USD2, USD3, and USD4 may include performing an epitaxial growth process in which the first, second, third, and fourth semiconductor patterns SP1, SP2, SP3, and SP4, the semiconductor sacrificial patterns 88, and the sacrificial patterns 89 are used as seeds.

Upper cover dielectric layers 52 may be formed on the first, second, third, and fourth upper source/drain patterns USD1, USD2, USD3, and USD4. A dielectric layer 13 may be formed on the lower cover dielectric layer 51 and the upper cover dielectric layer 52.

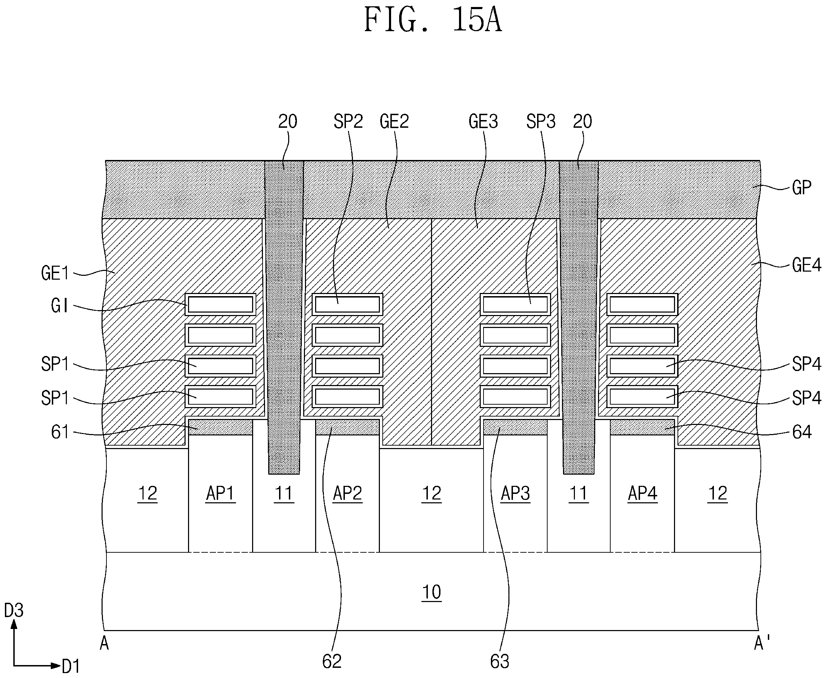

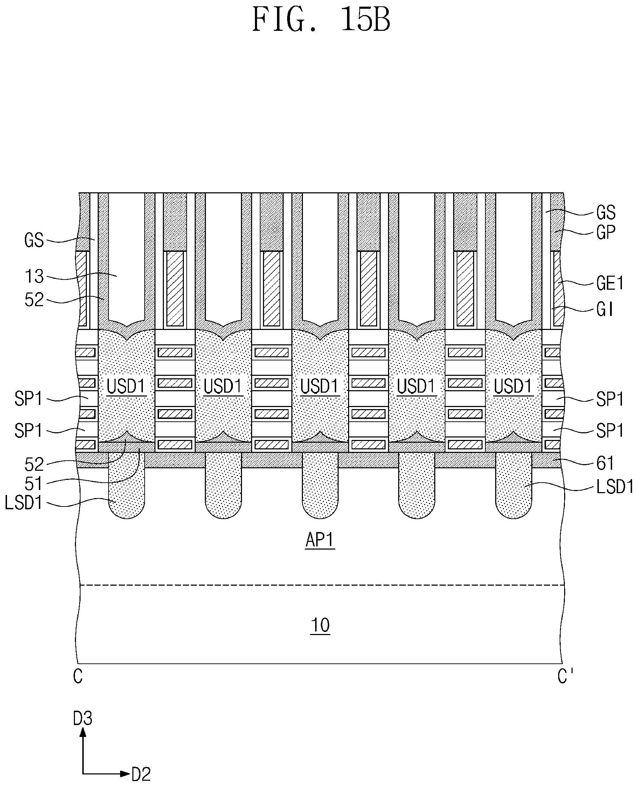

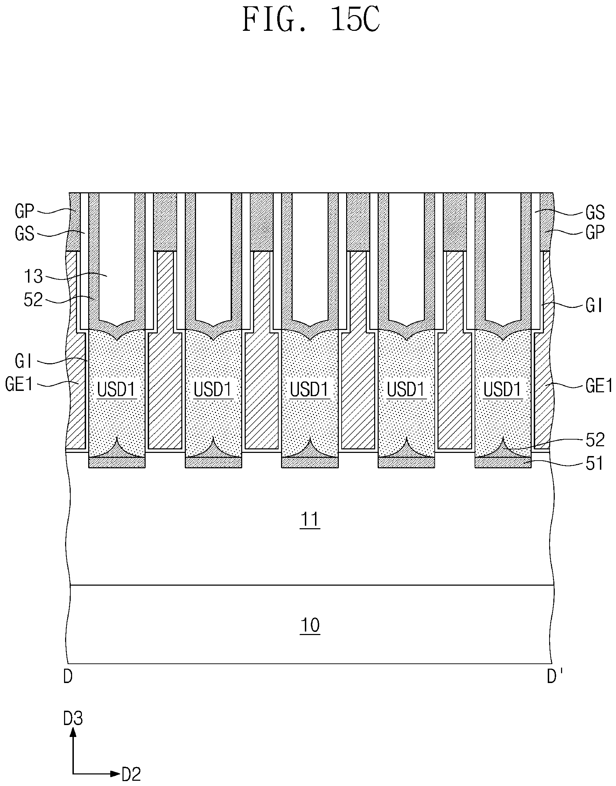

Referring to FIGS. 15A, 15B, and 15C, the gate mask patterns 73, the second gate sacrificial layers 72, the first gate sacrificial layers 71, the semiconductor sacrificial patterns 88, and the sacrificial patterns 89 may be removed. In some embodiments, the semiconductor sacrificial patterns 88 and the sacrificial patterns 89 may be removed by a process that selectively removes silicon-germanium.

Gate dielectric layers GI, gate electrodes GE1, GE2, GE3, and GE4, and gate capping patterns GP may be formed in empty spaces formed by removing the gate mask patterns 73, the second gate sacrificial layers 72, the first gate sacrificial layers 71, the semiconductor sacrificial patterns 88, and the sacrificial patterns 89.

Referring to FIGS. 1B, 1C, 1D, and 1E, gate contacts 45 and active contacts 41 may be formed.

In a method of fabricating a semiconductor device according to some embodiments, as the sacrificial pattern 89 is formed and then the separation dielectric layer 20 is formed, semiconductor patterns may have a relatively uniform width.

In a method of fabricating a semiconductor device according to some embodiments, as the gate spacer GS is formed and then the separation dielectric layer 20 is formed, the gate spacer GS may not remain on a sidewall of the separation dielectric layer 20. Therefore, in a process that removes the semiconductor sacrificial pattern 88 and the sacrificial pattern 89, it may be possible to limit and/or prevent a phenomenon in which neither the semiconductor sacrificial pattern 88 nor the sacrificial pattern 89 is partially removed due to the gate spacer GS that remains on the sidewall of the separation dielectric layer 20.

In a method of fabricating a semiconductor device according to some embodiments, as semiconductor patterns are formed and then the separation dielectric layer 20 is formed, it may be possible to limit and/or prevent a reduction in height of the separation dielectric layer 20 in a process for forming the semiconductor patterns and to limit and/or prevent a phenomenon in which a height of the separation dielectric layer 20 is reduce to connect upper source/drain patterns to each other.

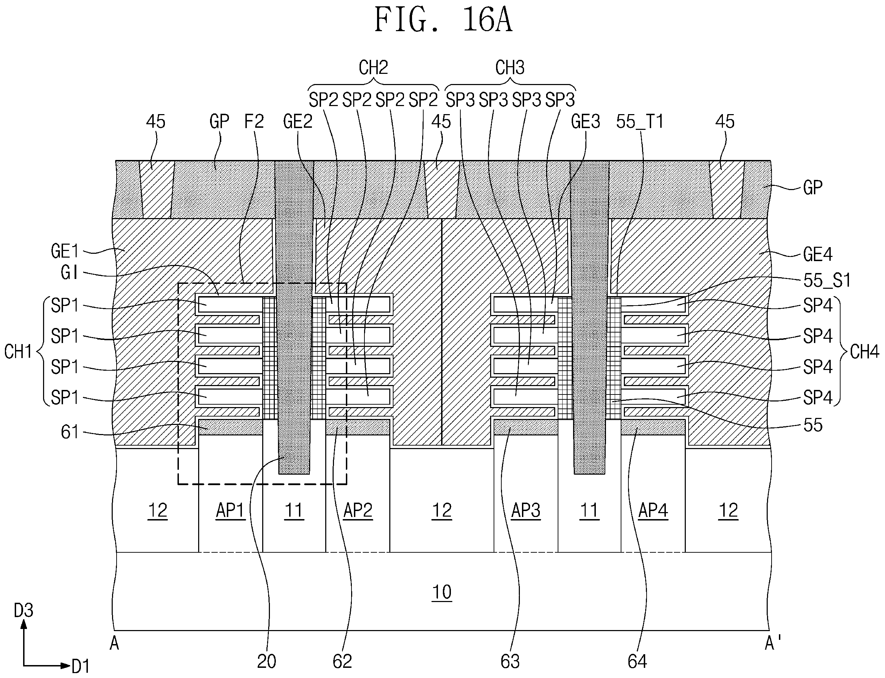

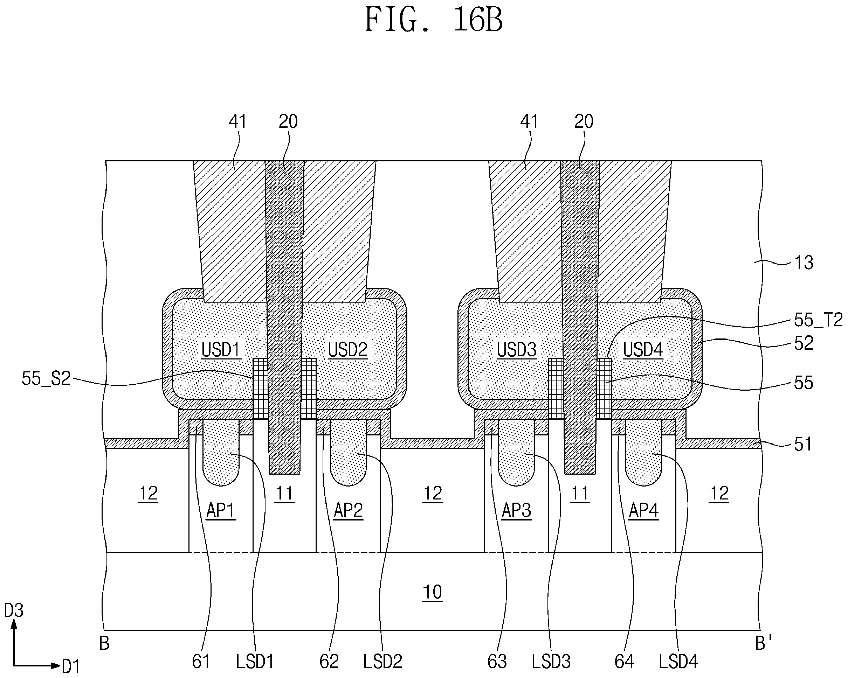

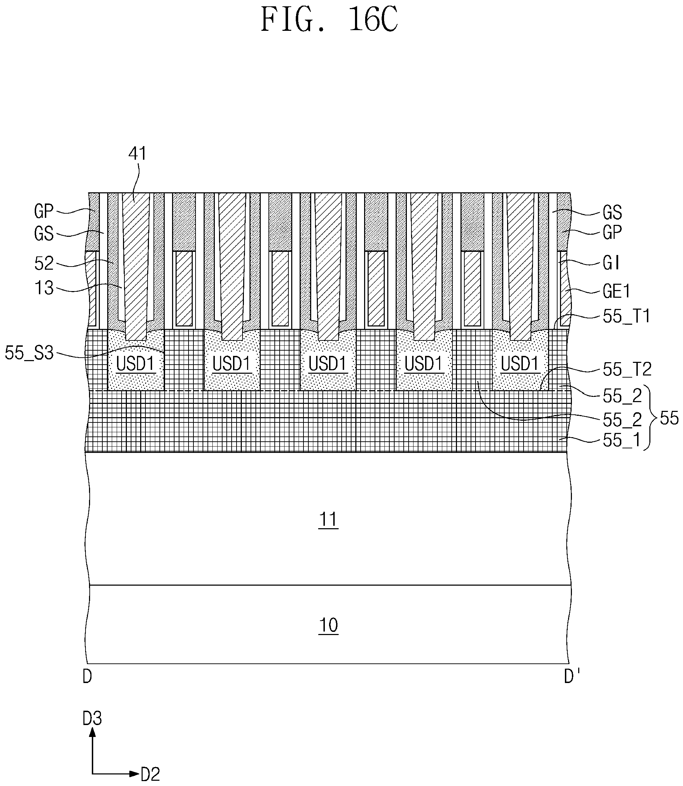

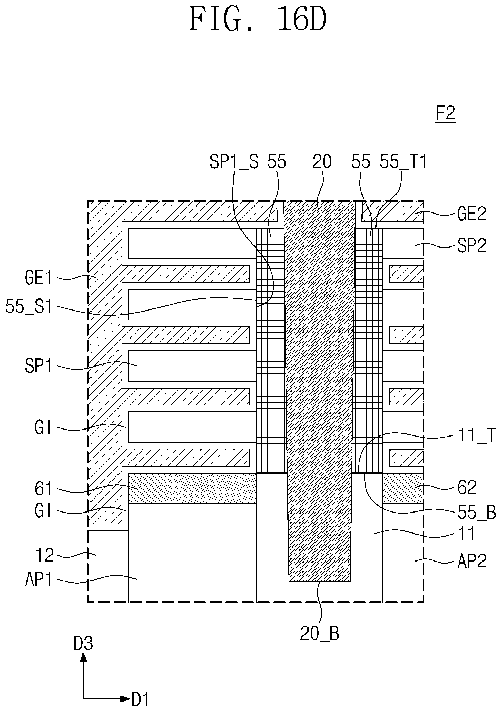

FIGS. 16A, 16B, and 16C illustrate cross-sectional views showing a semiconductor device according to some embodiments. FIG. 16D illustrates an enlarged view showing section F2 of FIG. 16A. FIG. 16A may correspond to FIG. 1B. FIG. 16B may correspond to FIG. 1C. FIG. 16C may correspond to FIG. 1E. Except for that mentioned below, a semiconductor device of FIGS. 16A to 16D may be similar to the semiconductor device of FIGS. 1A to 1G.

Referring to FIGS. 16A, 16B, 16C, and 16D, intervening dielectric patterns 55 may be provided. The intervening dielectric pattern 55 may be provided on the first device isolation layer 11. The intervening dielectric pattern 55 may overlap in the third direction D3 with the first device isolation layer 11.

The intervening dielectric pattern 55 may include a dielectric material different from those of the separation dielectric layer 20, the first device isolation layer 11, and the second device isolation layer 12. For example, the intervening dielectric pattern 55 may include silicon carboxynitride or silicon carbonitride.

The intervening dielectric patterns 55 may extend in the second direction D2. The intervening dielectric patterns 55 may be arranged along the first direction D1. The intervening dielectric patterns 55 may be spaced apart from each other in the first direction D1. The separation dielectric layer 20 may be provided between the intervening dielectric patterns 55 that are adjacent to each other in the first direction D1. The intervening dielectric pattern 55 may be provided between the separation dielectric layer 20 and the channel structure CH1, CH2, CH3, or CH4.

The intervening dielectric pattern 55 may include a first part 55_1 and second parts 55_2. The first part 55_1 of the intervening dielectric pattern 55 may be located at a lower level than that of the second parts 55_2 of the intervening dielectric pattern 55. The second parts 55_2 of the intervening dielectric pattern 55 may protrude in the third direction D3 from the first part 55_1 of the intervening dielectric pattern 55. The second parts 55_2 of the intervening dielectric pattern 55 may be arranged along the second direction D2. The second parts 55_2 of the intervening dielectric pattern 55 may be spaced apart from each other in the second direction D2. A width in the second direction D2 of the first part 55_1 of the intervening dielectric pattern 55 may be greater than a width in the second direction D2 of the second part 55_2 of the intervening dielectric pattern 55.

The intervening dielectric pattern 55 may have first top surfaces 55_T1 and second top surfaces 55_T2. The first top surface 55_T1 of the intervening dielectric pattern 55 may be located at a higher level than that of the second top surface 55_T2 of the intervening dielectric pattern 55. A distance in the third direction D3 between the first top surface 55_T1 of the intervening dielectric pattern 55 and a bottom surface 55_B of the intervening dielectric pattern 55 may be greater than a distance in the third direction D3 between the second top surface 55_T2 of the intervening dielectric pattern 55 and the bottom surface 55_B of the intervening dielectric pattern 55. The bottom surface 55_B of the intervening dielectric pattern 55 may be in contact with the top surface 11_T of the first device isolation layer 11. The bottom surface 55_B of the intervening dielectric pattern 55 may be located at a higher level than that of the bottom surface 20_B of the separation dielectric layer 20.

The first top surface 55_T1 of the intervening dielectric pattern 55 may be in contact with the gate dielectric layer GI and the gate spacer GS. The second top surface 55_T2 of the intervening dielectric pattern 55 may be in contact with the upper source/drain pattern USD1, USD2, USD3, or USD4. The first top surface 55_T1 of the intervening dielectric pattern 55 may be a top surface of the second part 55_2 of the intervening dielectric pattern 55. The first top surface 55_T1 and the second top surface 55_T2 of the intervening dielectric pattern 55 may be connected to the sidewall of the separation dielectric layer 20.

In some embodiments, the first top surface 55_T1 of the intervening dielectric pattern 55 may be located at the same level as that of a top surface of an uppermost one of the semiconductor patterns SP1, SP2, SP3, and SP4 included in the channel structures CH1, CH2, CH3, and CH4.

The second top surface 55_T2 of the intervening dielectric pattern 55 may be located at a level lower than that of a top surface of the upper source/drain pattern USD1, USD2, USD3, or USD4 and higher than that of a bottom surface of the upper source/drain pattern USD1, USD2, USD3, or USD4.

The first top surface 55_T1 of the intervening dielectric pattern 55 may overlap in the third direction D3 with the gate electrode GE1, GE2, GE3, or GE4. The second top surface 55_T2 of the intervening dielectric pattern 55 may overlap in the third direction D3 with the upper source/drain pattern USD1, USD2, USD3, or USD4.

The intervening dielectric pattern 55 may be in contact with the separation dielectric layer 20. The intervening dielectric pattern 55 may have a first sidewall 55_S1 in contact with the semiconductor patterns SP1, SP2, SP3, or SP4, and may also have a second sidewall 55_S2 and a third sidewall 55_S3 in contact with the upper source/drain pattern USD1, USD2, USD3, or USD4. The first and second sidewalls 55_S1 and 55_S2 of the intervening dielectric pattern 55 may be parallel to the second direction D2. The third sidewall 55_S3 of the intervening dielectric pattern 55 may be parallel to the first direction D1.

A height in the third direction D3 of the first sidewall 55_S1 of the intervening dielectric pattern 55 may be greater than heights in the third direction D3 of the second and third sidewalls 55_S2 and 55_S3 of the intervening dielectric pattern 55. The third sidewall 55_S3 of the intervening dielectric pattern 55 may be a sidewall of the second part 55_2 of the intervening dielectric pattern 55.

When viewed in cross-section as shown in FIG. 16D, a width in the first direction D1 of the separation dielectric layer 20 may be, for example, about 1.8 times to about 3 times a width in the first direction D1 of the intervening dielectric pattern 55. When viewed in cross-section as shown in FIG. 16D, a distance in the first direction D1 of the intervening dielectric pattern 55 may range, for example, about 5 nm to about 11 nm.

Each of the semiconductor patterns SP1, SP2, SP3, and SP4 may have a sidewall in contact with the first sidewall 55_S1 of the intervening dielectric pattern 55. For example, the first semiconductor pattern SP1 may have a sidewall SP1_S in contact with the first sidewall 55_S12 of the intervening dielectric pattern 55.

The gate dielectric layer GI may be in contact with the first sidewall 55_S1 of the intervening dielectric pattern 55. The lower cover dielectric layer 51 and the upper cover dielectric layer 52 may be in contact with the second sidewall 55_S2 of the intervening dielectric pattern 55.

As the intervening dielectric pattern 55 is provided between the separation dielectric layer 20 and a gate electrode of a semiconductor device according to some embodiments, semiconductor patterns may have a relatively uniform width, and there may be a relative reduction in distribution of current that flows through the semiconductor patterns.

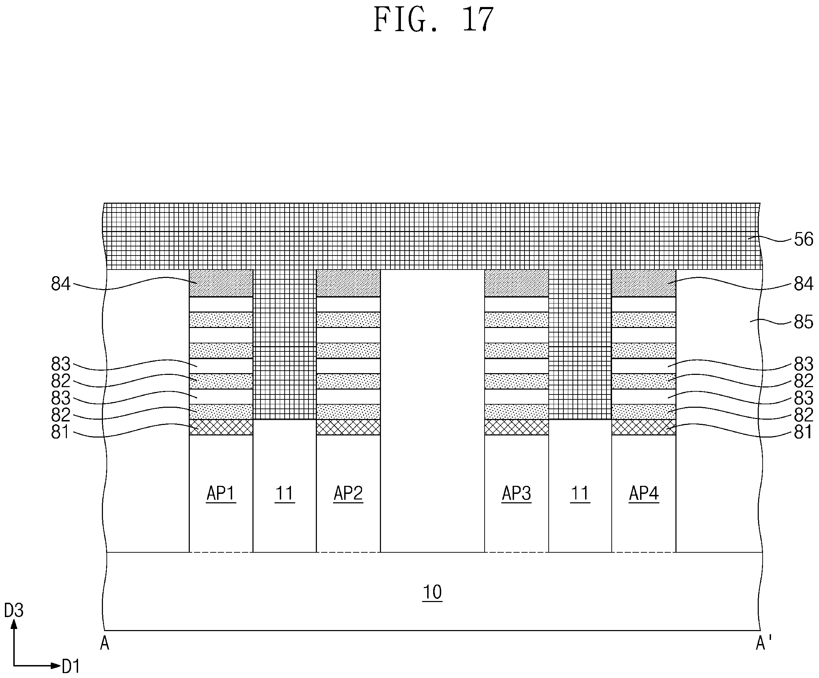

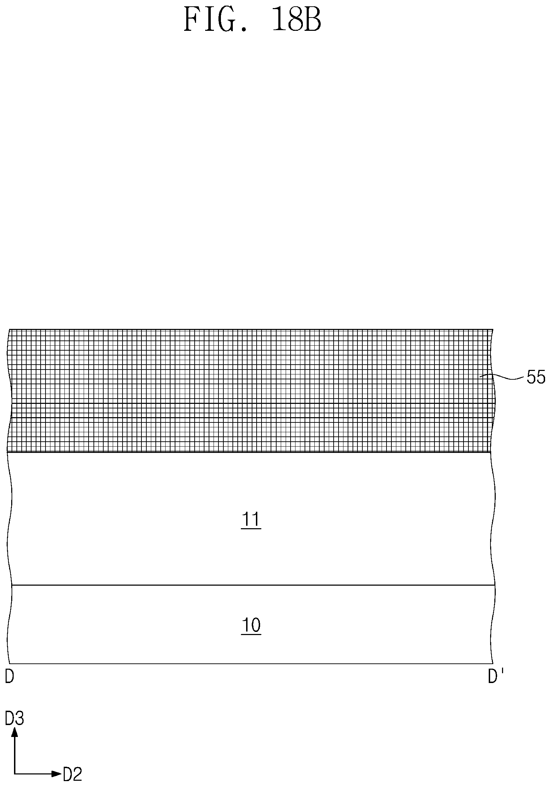

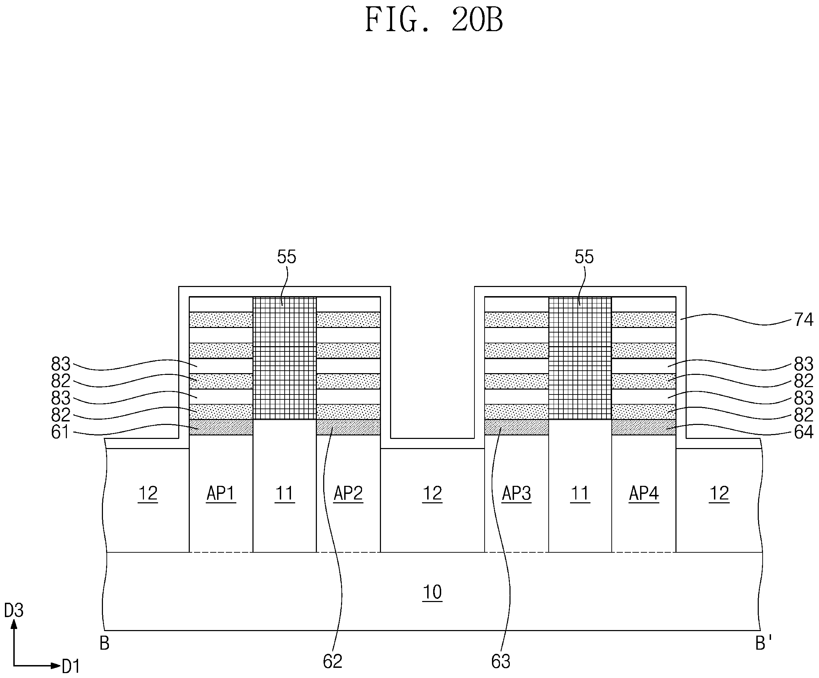

FIGS. 17, 18A, 18B, 19, 20A, 20B, 21A, 21B, 21C, 22A, 22B, 22C, 23A, 23B, 24A, 24B, 25A, And 25B illustrate cross-sectional views showing a method of fabricating a semiconductor device according to some embodiments. FIGS. 17, 18A, 19, 20A, 21A, 22A, 23A, and 25A may correspond to FIG. 16A. FIGS. 20B, 21B, 22B, 23B, and 24A may correspond to FIG. 16B. FIGS. 18B, 21C, 22C, 24B, and 25B may correspond to FIG. 16C.

Referring to FIG. 17, similar to that discussed in FIGS. 2A to 7, a substrate 10 including active patterns AP1, AP2, AP3, and AP4 may be provided and first device isolation layers 11, first, second, and third semiconductor layers 81, 82, and 83, mask patterns 84, and a preliminary separation layer 85 may be formed on the substrate 10.

A preliminary pattern layer 56 may be formed on the first device isolation layers 11, the mask patterns 84, and the preliminary separation layer 85. For example, the preliminary pattern layer 56 may be formed by a deposition process. The preliminary pattern layer 56 may include, for example, silicon carboxynitride or silicon carbonitride.

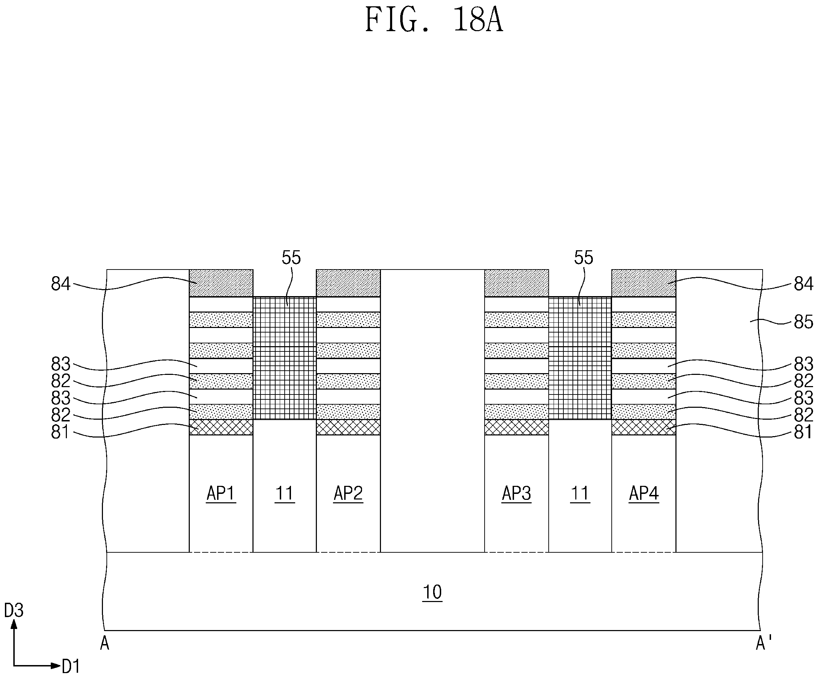

Referring to FIGS. 18A and 18B, the preliminary pattern layer 56 may be etched. The preliminary pattern layer 56 may be etched into a plurality of intervening dielectric patterns 55.

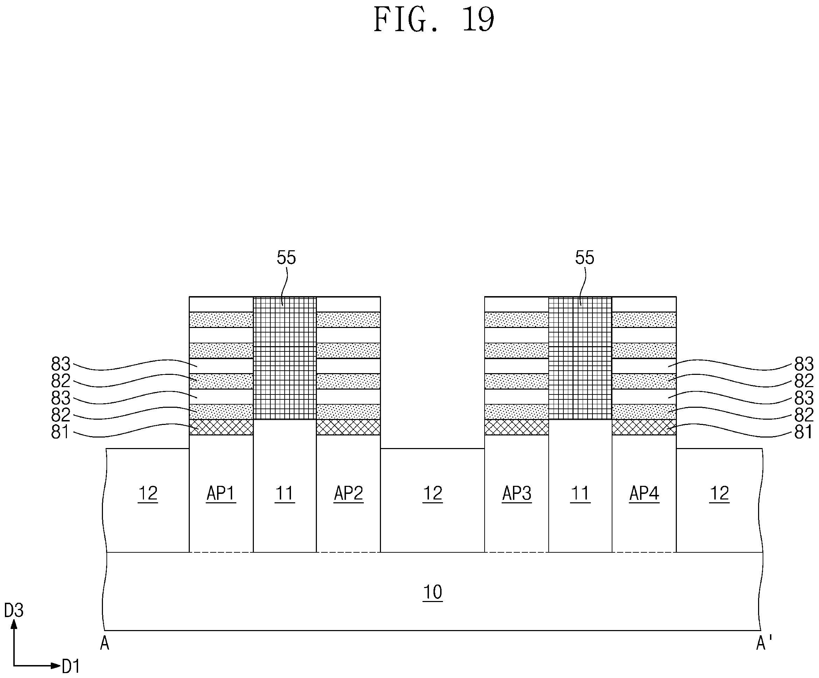

Referring to FIG. 19, second device isolation layers 12 may be formed. The preliminary separation layer 85 may be etched to form the second device isolation layers 12. As the intervening dielectric pattern 55 is disposed on the first device isolation layer 11, the first device isolation layer 11 may not be etched in a process for forming the second device isolation layer 12. The mask patterns 84 may be removed.

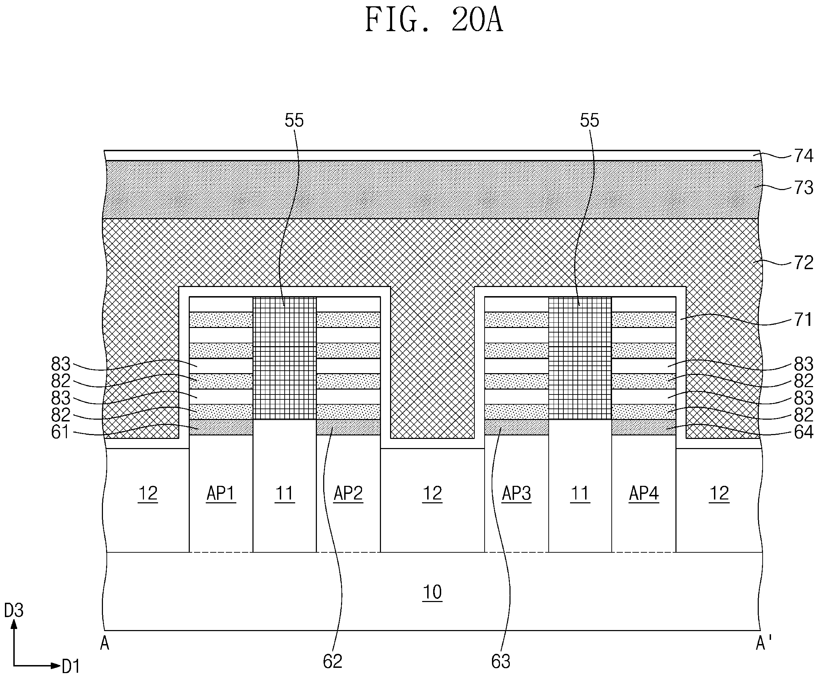

Referring to FIGS. 20A and 20B, first, second, third, and fourth lower dielectric patterns 61, 62, 63, and 64 may be formed. There may be formed first gate sacrificial layers 71, second gate sacrificial layers 72, gate mask patterns 73, and a preliminary gate spacer layer 74. The first gate sacrificial layer 71 may be in contact with a top surface of the intervening dielectric pattern 55. The preliminary gate spacer layer 74 may be in contact with the top surface of the intervening dielectric pattern 55.

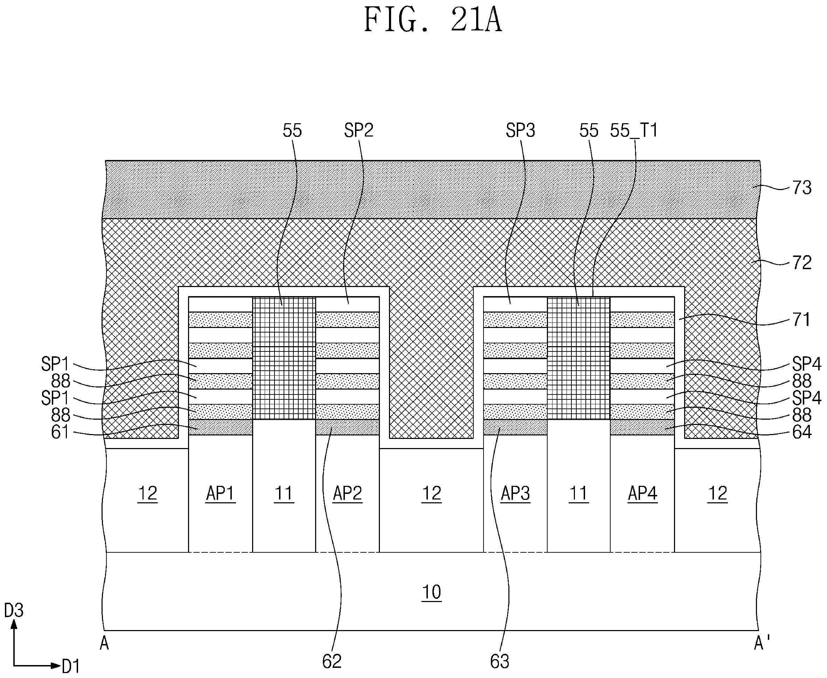

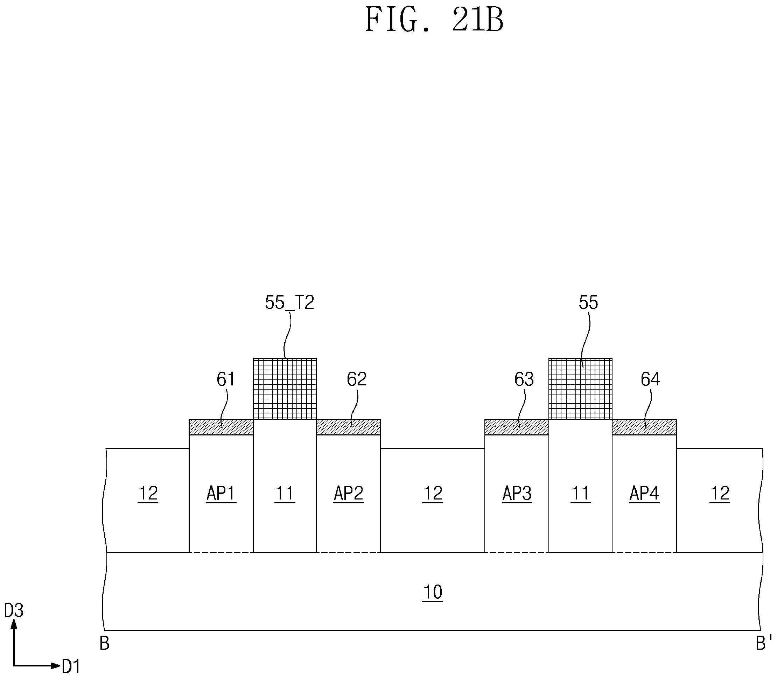

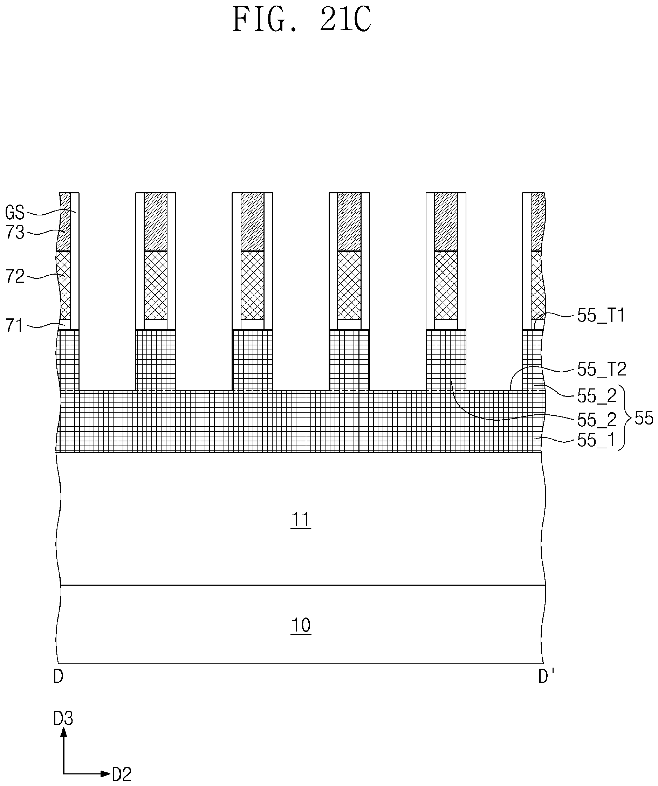

Referring to FIGS. 21A, 21B, and 21C, the preliminary gate spacer layer 74 may be etched. The etching of the preliminary gate spacer layer 74 may form gate spacers GS. The etching of the preliminary gate spacer layer 74 may include etching the second and third semiconductor layers 82 and 83 and portions of the intervening dielectric patterns 55 may be exposed between the gate spacers GS.

The second and third semiconductor layers 82 and 83 and the intervening dielectric patterns 55 may be etched. The second and third semiconductor layers 82 and 83 and portions of the intervening dielectric patterns 55 that are exposed between the gate spacers GS may be removed. One second semiconductor layer 82 may be separated into a plurality of semiconductor sacrificial patterns 88. One third semiconductor layer 83 may be separated into a plurality of semiconductor patterns SP1, SP2, SP3, and SP4.

The intervening dielectric pattern 55 may be etched to define first top surfaces 55_T1 and second top surfaces 55_T2 of the intervening dielectric pattern 55, and also to define a first part 55_1 and second parts 55_2 of the intervening dielectric pattern 55.

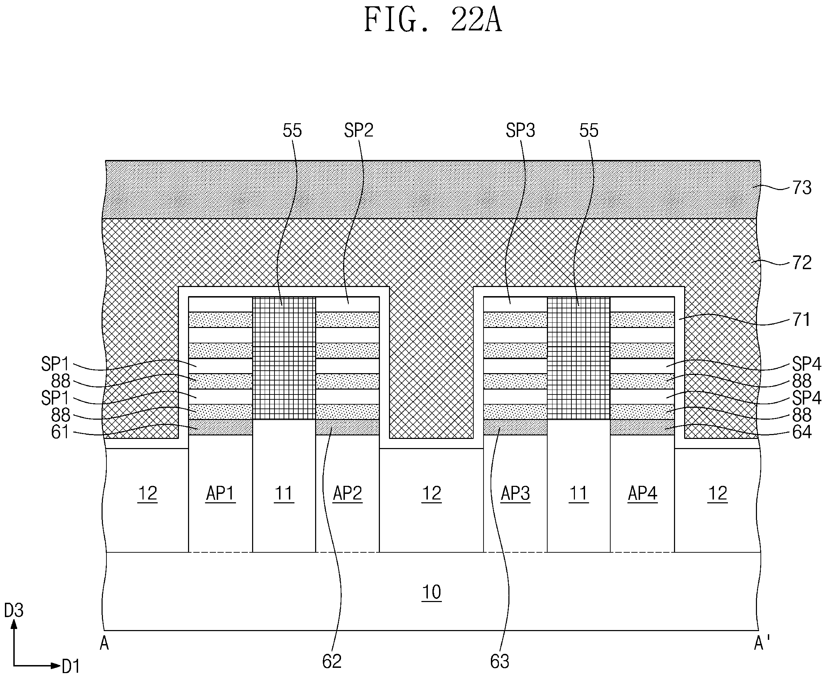

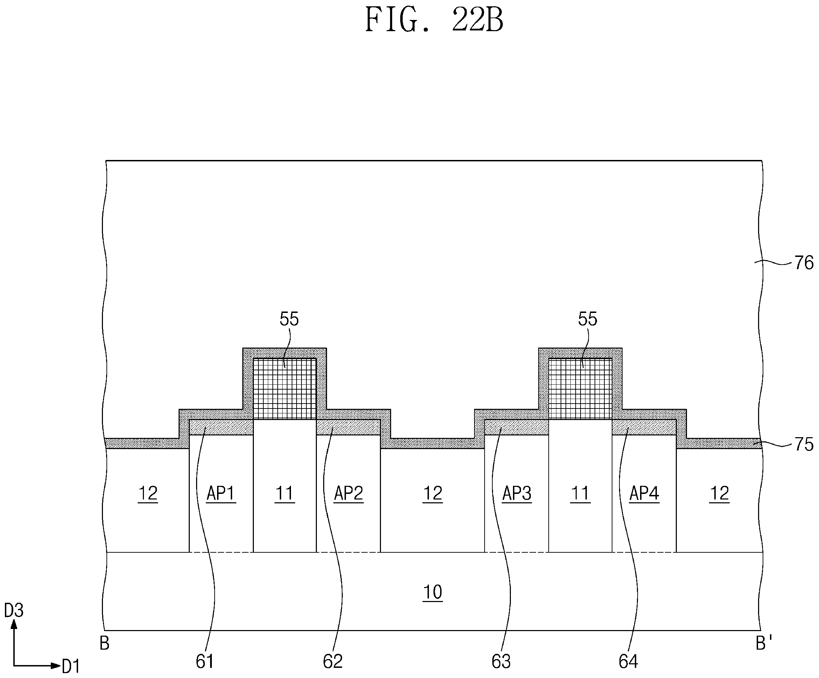

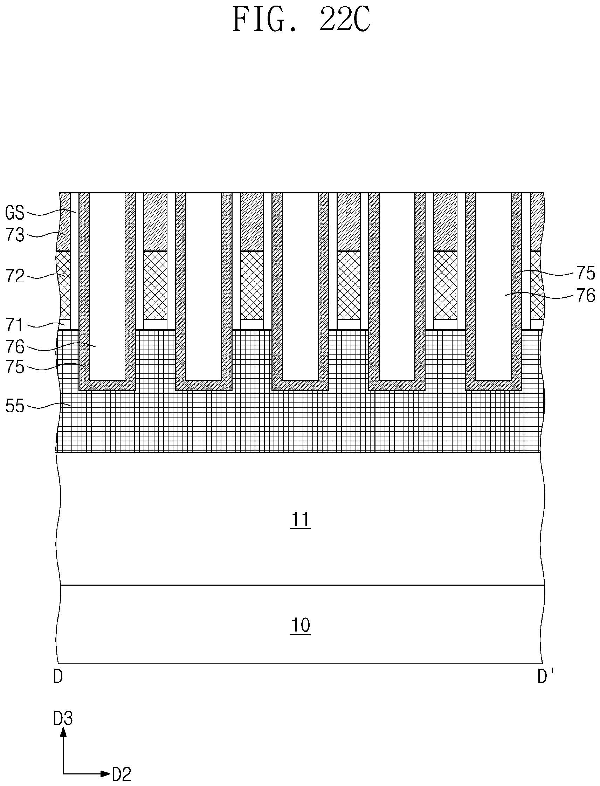

Referring to FIGS. 22A, 22B, and 22C, dielectric liners 75 may be formed. The dielectric liner 75 may be formed on the second device isolation layers 12, the first, second, third, and fourth lower dielectric patterns 61, 62, 63, and 64, the intervening dielectric patterns 55, and the gate spacers GS.

Gap-fill layers 76 may be formed. The gap-fill layer 76 may be formed on the dielectric liner 75.

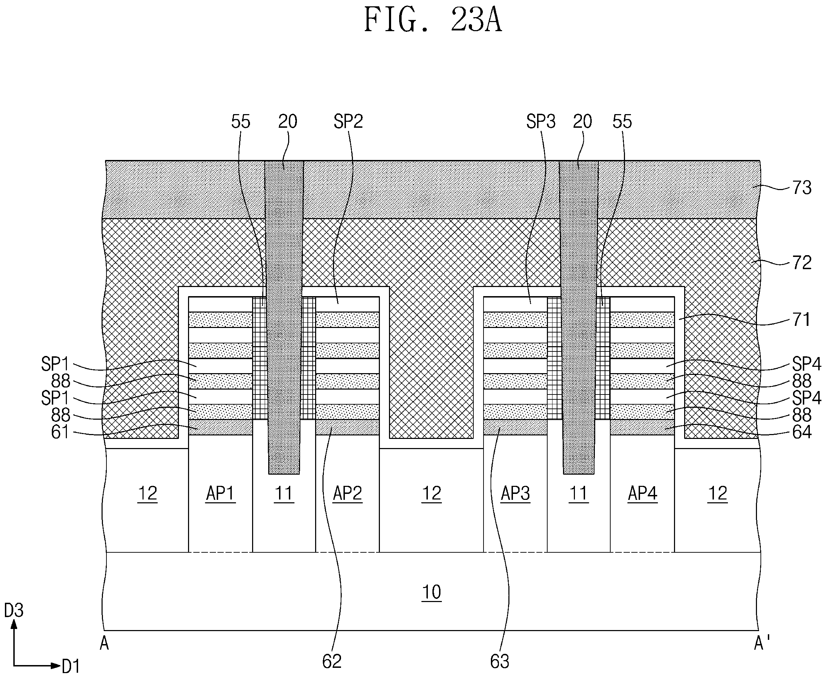

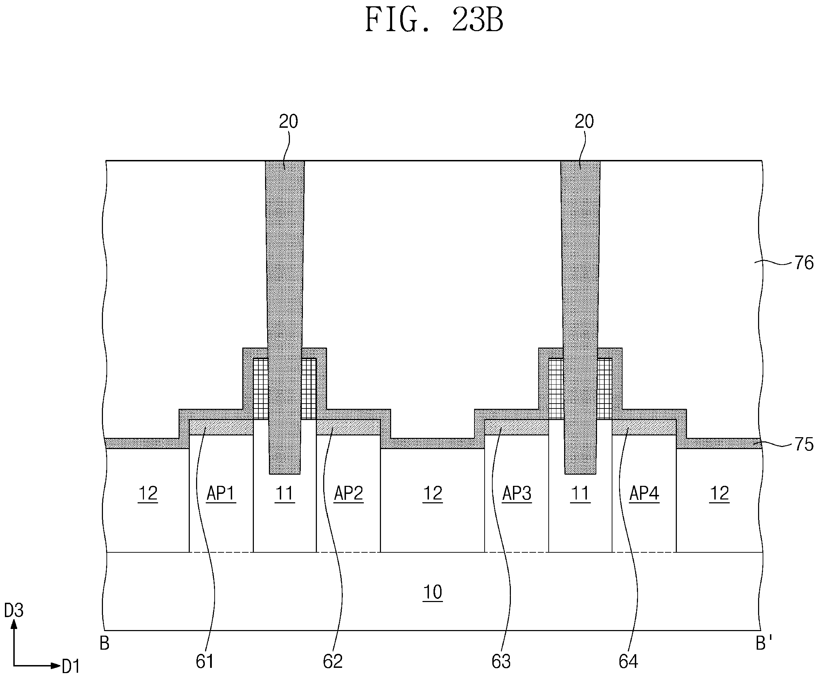

Referring to FIGS. 23A and 23B, separation dielectric layers 20 may be formed. The separation dielectric layer 20 may penetrate the gate mask pattern 73, the second gate sacrificial layer 72, the first gate sacrificial layer 71, the intervening dielectric pattern 55, and the dielectric liner 75.

The formation of the separation dielectric layer 20 may include forming a trench that penetrates the gate mask pattern 73, the second gate sacrificial layer 72, the first gate sacrificial layer 71, the intervening dielectric pattern 55, and the dielectric liner 75, and forming the separation dielectric layer 20 that fills the trench. The formation of the separation dielectric layer 20 may separate one intervening dielectric pattern 55 into two intervening dielectric patterns 55. The two intervening dielectric patterns 55 may be in contact with the separation dielectric layer 20.

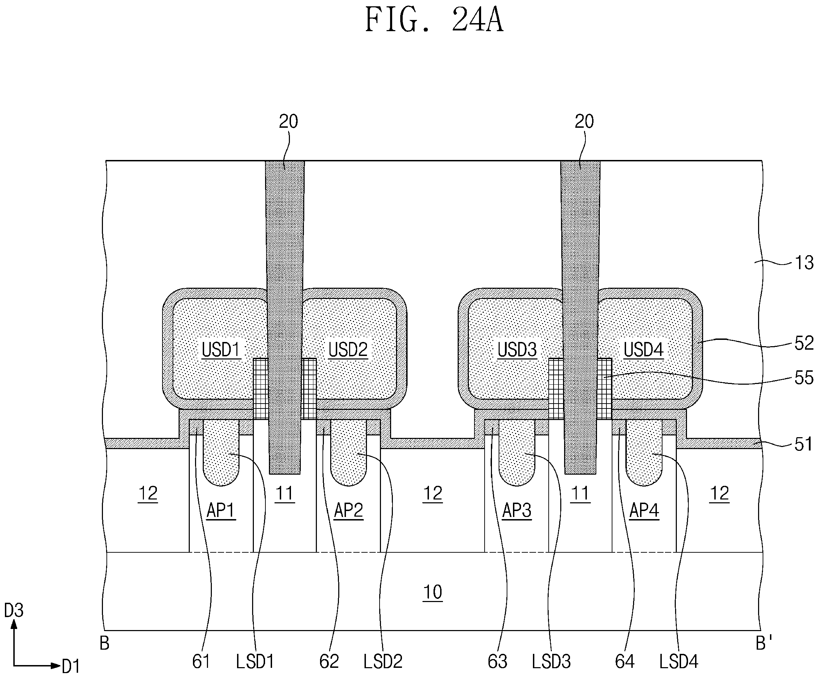

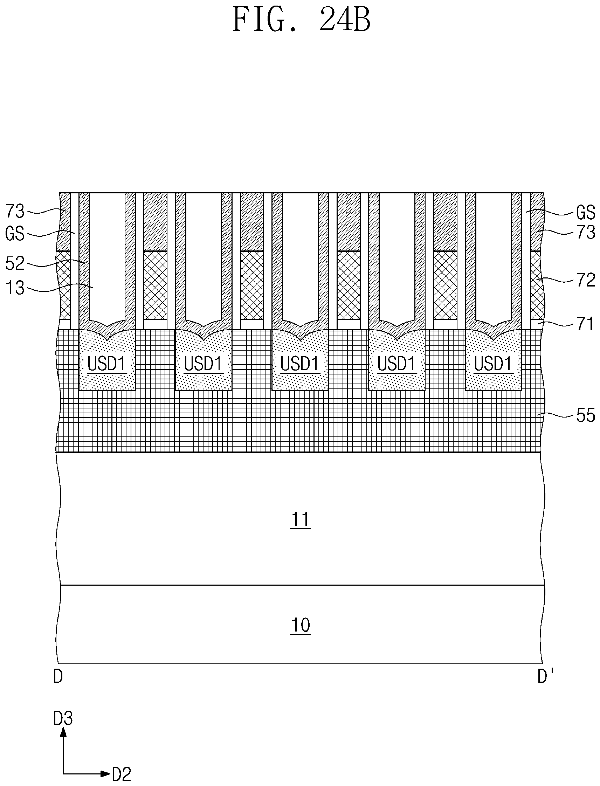

Referring to FIGS. 24A and 24B, the gap-fill layer 76 and the dielectric liner 75 may be removed. First, second, third, and fourth lower source/drain patterns LSD1, LSD2, LSD3, and LSD4 may be formed.

Lower cover dielectric layers 51 may be formed. The formation of the lower cover dielectric layers 51 may include forming a preliminary lower cover dielectric layer on the second device isolation layer 12, the first, second, third, and fourth lower dielectric patterns 61, 62, 63, and 64, the first, second, third, and fourth semiconductor patterns SP1, SP2, SP3, and SP4, the semiconductor sacrificial patterns 88, and the intervening sacrificial patterns 55, and etching the preliminary lower cover dielectric layer to expose the first, second, third, and fourth semiconductor patterns SP1, SP2, SP3, and SP4, the semiconductor sacrificial patterns 88, and the intervening sacrificial patterns 55.

First, second, third, and fourth upper source/drain patterns USD1, USD2, USD3, and USD4 may be formed. Upper cover dielectric layers 52 may be formed on the first, second, third, and fourth upper source/drain patterns USD1, USD2, USD3, and USD4. A dielectric layer 13 may be formed on the lower cover dielectric layer 51 and the upper cover dielectric layer 52.

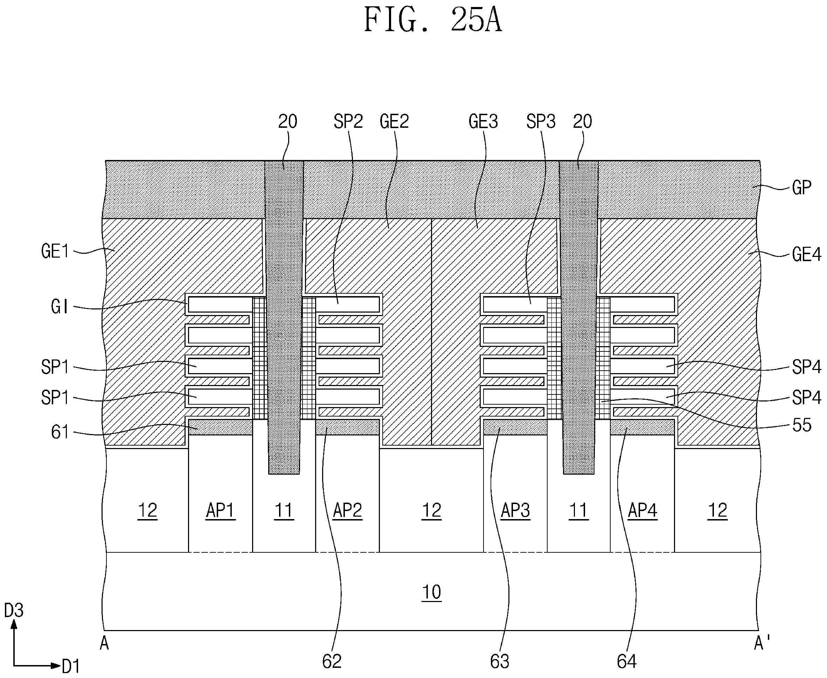

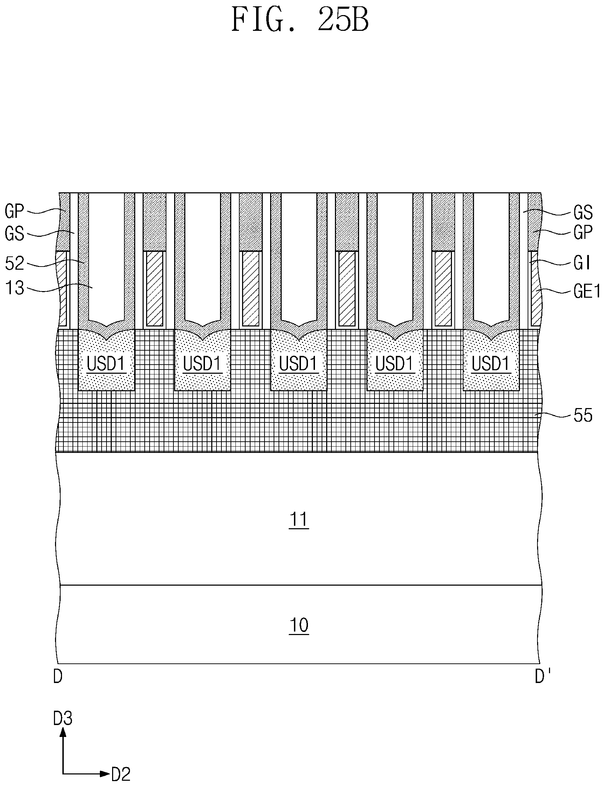

Referring to FIGS. 25A and 25B, the gate mask pattern 73, the second gate sacrificial layers 72, first gate sacrificial layers 71, and the semiconductor sacrificial patterns 88 may be removed.

Gate dielectric layers GI, gate electrodes GE1, GE2, GE3, and GE4, and gate capping patterns GP may be formed in empty spaces formed by removing the gate mask patterns 73, the second gate sacrificial layers 72, the first gate sacrificial layers 71, and the semiconductor sacrificial patterns 88.

Referring to FIGS. 16A, 16B, and 16C, gate contacts 45 and active contacts 41 may be formed. The gate contacts 45 may be formed through the capping patterns GP to contact the gate electrodes GE1, GE2, GE3, and GE4. The active contacts 41 may be formed through the dielectric layer 13 to contact the first, second, third, and fourth upper source/drain patterns USD1, USD2, USD3, and USD4.

In a method of fabricating a semiconductor device according to some embodiments, as the intervening dielectric pattern 55 is formed and then the separation dielectric layer 20 is formed, semiconductor patterns may have a relatively uniform width.

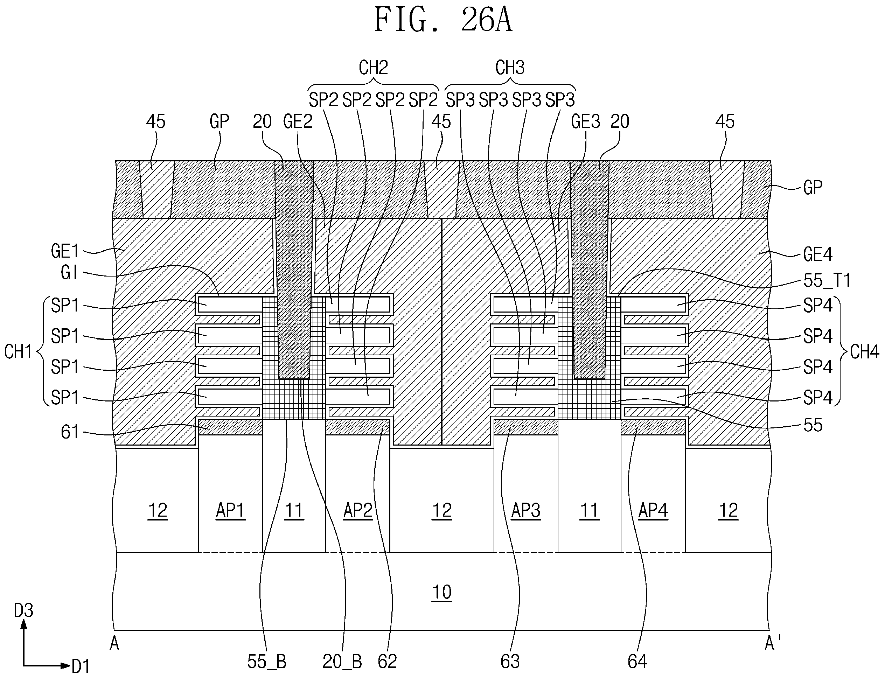

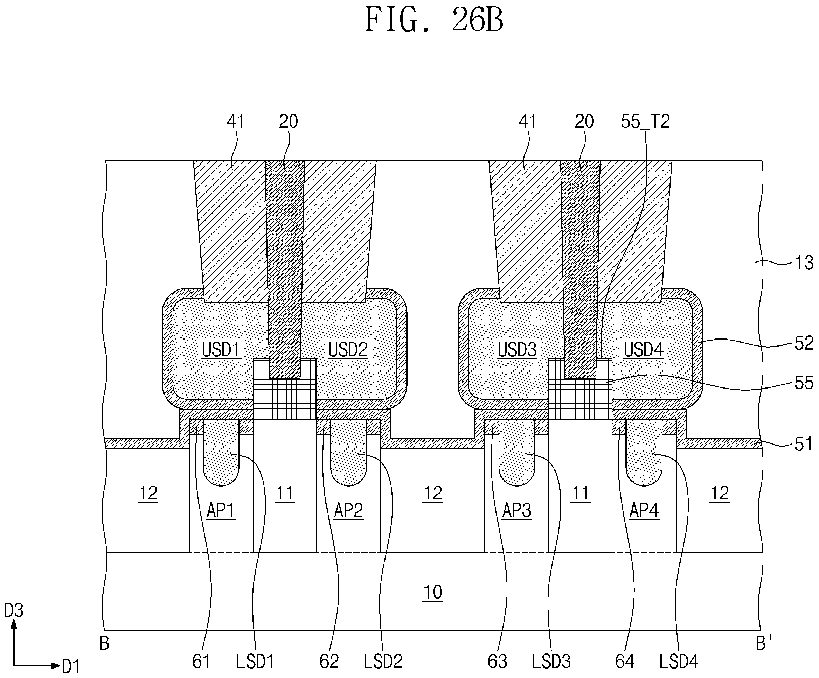

FIGS. 26A and 26B illustrate cross-sectional views showing a semiconductor device according to some embodiments. FIG. 26A may correspond to FIG. 16A. FIG. 26B may correspond to FIG. 16B. Except for that mentioned below, a semiconductor device of FIGS. 26A and 26B may be similar to the semiconductor device of FIGS. 16A to 16D.

Referring to FIGS. 26A and 26B, a lower portion of the separation dielectric layer 20 may be disposed in the intervening dielectric pattern 55. The bottom surface 20_B of the separation dielectric layer 20 may be disposed in the intervening dielectric pattern 55. One of the intervening dielectric patterns 55 may be in contact with the first and second semiconductor patterns SP1 and SP2and the first and second upper source/drain patterns USD1 and USD2, and another of the intervening dielectric patterns 55 may be in contact with the third and fourth semiconductor patterns SP3 and SP4 and the third and fourth upper source/drain patterns USD3 and USD4.

The bottom surface 20_B of the separation dielectric layer 20 may be located at a lower level than that of the first top surface 55_T1 of the intervening dielectric pattern 55 and that of the second top surface 55_T2 of the intervening dielectric pattern 55. The bottom surface 20_B of the separation dielectric layer 20 may be located at a higher level than that of the bottom surface 55_B of the intervening dielectric pattern 55.

In a semiconductor device according to some embodiments of inventive concepts, as semiconductor patterns may have a relatively uniform width, and the semiconductor device may have improved electrical properties.

In a method of fabricating a semiconductor device according to some embodiments of inventive concepts, as a gate spacer layer and a semiconductor may be formed and then a separation dielectric layer may be formed. The semiconductor device may have improved electrical properties.

Although some embodiments of inventive concepts have been discussed with reference to accompanying figures, it will be understood that various changes in form and details may be made therein without departing from the scope of inventive concepts. It therefore will be understood that the embodiments described above are just illustrative but not limitative in all aspects.

## Claims

1. A semiconductor device, comprising:
a first active pattern;
a second active pattern spaced apart at a first distance from the first active pattern;
a third active pattern spaced apart at a second distance from the second active pattern;
a first device isolation layer between the first active pattern and the second active pattern;
a second device isolation layer between the second active pattern and the third active pattern;
a first channel structure overlapping the first active pattern;
a second channel structure overlapping the second active pattern;
a third channel structure overlapping the third active pattern; and
a separation dielectric layer between the first channel structure and the second channel structure,
wherein the second active pattern is between the first active pattern and the third active pattern,
wherein the first distance is less than the second distance,
wherein the separation dielectric layer overlaps the first device isolation layer, and
wherein a level of a top surface of the first device isolation layer is higher than a level of a top surface of the second device isolation layer.

2. The semiconductor device of claim 1, wherein a level of a bottom surface of the separation dielectric layer is lower than the level of the top surface of the first device isolation layer.

3. The semiconductor device of claim 1 or claim 2, wherein a level of a bottom surface of the separation dielectric layer is higher than a level of a bottom surface of the first device isolation layer.

4. The semiconductor device of any preceding claim, wherein the separation dielectric layer and the first device isolation layer include different dielectric materials from each other.

5. The semiconductor device of any preceding claim, wherein a width of the first device isolation layer is greater than a width of the separation dielectric layer.

6. The semiconductor device of any preceding claim, further comprising:
a gate electrode overlapping the first channel structure,
wherein the first channel structure includes a plurality of semiconductor patterns overlapping each other,
wherein a first part of the gate electrode is between the plurality of semiconductor patterns, and
wherein a second part of the gate electrode is between the plurality of semiconductor patterns and the separation dielectric layer.

7. The semiconductor device of any preceding claim, further comprising:
a first gate electrode overlapping the first channel structure; and
a first upper source/drain pattern connected to the first channel structure, wherein:
the top surface of the first device isolation layer includes a first top surface and a second top surface,
the first top surface of the first device isolation layer overlaps the first gate electrode,
the second top surface of the first device isolation layer overlaps the first upper source/drain pattern,
a level of the first top surface of the first device isolation layer is higher than a level of the second top surface of the first device isolation layer.

8. The semiconductor device of claim 7, further comprising:
a gate dielectric layer between the first top surface of the first device isolation layer and the first gate electrode; and
a lower cover dielectric layer between the second top surface of the first device isolation layer and the first upper source/drain pattern,
wherein the first top surface of the first device isolation layer is in contact with the gate dielectric layer, and
wherein the second top surface of the first device isolation layer is in contact with the lower cover dielectric layer.

9. The semiconductor device of any preceding claim, wherein:
the first device isolation layer includes a first part and a plurality of second parts protruding from the first part, and
a width of the first part of the first device isolation layer is greater than a width of each of the plurality of second parts of the first device isolation layer.

10. The semiconductor device of claim 9, wherein the plurality of second parts of the first device isolation layer are spaced apart from each other.

11. The semiconductor device of any of claims 1 to 7, further comprising:
an intervening dielectric pattern between the first channel structure and the separation dielectric layer,
wherein a level of a bottom surface of the intervening dielectric pattern is higher than a level of a bottom surface of the separation dielectric layer.

12. The semiconductor device of any of claims 1 to 7 or claim 11, further comprising:
an intervening dielectric pattern between the first channel structure and the separation dielectric layer,
wherein the intervening dielectric pattern includes a first part and a second part protruding from the first part,
a width of the first part of the intervening dielectric pattern is greater than a width of the second part of the intervening dielectric pattern.

13. The semiconductor device of claim 12, further comprising:
an upper source/drain pattern in contact with a top surface of the second part of the intervening dielectric pattern and a sidewall of the second part of the intervening dielectric pattern, wherein
the upper source/drain pattern is in contact with a sidewall of the separation dielectric layer.

14. The semiconductor device of claim 13, wherein
the top surface of the second part of the intervening dielectric pattern is connected to the sidewall of the separation dielectric layer.
